Europäisches Patentamt

**European Patent Office**

Office européen des brevets

(19)

(11) Veröffentlichungsnummer: **0 062 235**
A2

(12) # EUROPÄISCHE PATENTANMELDUNG

(21) Anmeldenummer: **82102442.9**

(22) Anmeldetag: **24.03.82**

(51) Int. Cl.³: **G 11 C 11/42**

(30) Priorität: **02.04.81 SE 8102109**

(43) Veröffentlichungstag der Anmeldung: **13.10.82**
**Patentblatt 82/41**

(84) Benannte Vertragsstaaten: **CH DE FR GB LI**

(71) Anmelder: **ASEA AB, S-721 83 Västeras (SE)**

(72) Erfinder: **Brogärdh, Torgny, Plätverksgatan 140,**
**S-724 74 Västeräs (SE)**
Erfinder: **Ovrén, Christer, Dr. Ing., Vilddjursvägen 9,**
**S-722 43 Västerås (SE)**
Erfinder: **Adolfsson, Morgan, Dipl.-Ing., Sigfrid Edströms**
**Gata 86, S-724 66 Västeräs (SE)**

(74) Vertreter: **Boecker, Joachim, Dr.-Ing.,**
**Rathenauplatz 2-8, D-6000 Frankfurt a.M. 1 (DE)**

(54) **Anordnung zur Umwandlung von Informationen aus der elektrischen Form in die optische Form und umgekehrt.**

(57) Die Erfindung betrifft eine Anordnung zur Umwandlung von Informationen aus der elektrischen Form in die optische Form (und umgekehrt), wobei die optische Informationsform eine in einer, zwei oder drei Richtungen zeitlich variierende Lichtintensität ist und wobei die Umwandlung der Information aus der elektrischen in die optische Form durch optische Modulatoren, z.B. Flüssigkristalle, erfolgt und die Umwandlung aus der optischen Form in die elektrische Form durch Fotodetektoren erfolgt. Die optischen Modulatoren und die Fotodetektoren werden zeitlich von einem oder mehreren elektrooptisch rückgekoppelten Kreisen gesteuert oder abgetastet, in denen sich mindestens ein optischer Modulator 2 im Strahlengang zwischen mindestens einer Lichtquelle 3, z.B. einer Leuchtdiode oder Laserdiode, und mindestens einem Fotodetektor 4, z.B. einem Fotowiderstand oder einer Fotodiode, befindet. Der Fotodetektor 4 ist in mindestens einen elektrischen Kreis 4, 5, 6 eingeschaltet, an welchen der optische Modulator 2 derart angeschlossen ist, daß man über einen Rückkopplungskreis, dessen Verhalten – in Kreisrichtung gesehen – bestimmt wird durch die Lichttransmission des optischen Modulators 2, die elektrische Eigenschaft des Fotodetektors und das elektrische Eingangssignal des optischen Modulators 2, eine positive und negative Rückkopplung erhält. Die elektrooptisch rückgekoppelten Kreise können auch mehr als einen optischen Modulator und Fotodetektor enthalten, aus denen eine elektrooptisch rückgekoppelte Kreuzschaltung aufgebaut wird.

Patentanwalt und Rechtsanwalt
Dr.-Ing. Dipl.-Ing. Joachim B o e c k e r

6 Frankfurt / Main 1
Rathenauplatz 2 - 8
Telefon: (06 11) *28 23 55
Telex: 4 189 066 itax d

0062235
08.03.1982
21 087 PE

## ASEA AB, Västeras, Schweden

### Anordnung zur Umwandlung von Informationen aus der elektrischen Form in die optische Form und umgekehrt

Die Erfindung betrifft eine Anordnung zur Umwandlung von Informationen aus der elektrischen Form in die optische Form und/oder umgekehrt gemäß dem Oberbegriff des Anspruches 1.

Zur Adressierung von flachen Displays werden z.Zt. im wesentlichen xy-Matrizen benutzt, die an IC-Schaltkreise (integrierte Schaltkreise) zur Adressierung und Multiplexierung angeschlossen werden. Bei beispielsweise 512 x 512 Bildelementen sind dabei 1024 elektrische Verbindungen zwischen den IC-Schaltkreisen und dem Display erforderlich.

Der Erfindung liegt die Aufgabe zugrunde, eine Anordnung der eingangs genannten Art zu entwickeln, mit der es möglich ist, bei der vorstehend beispielsweise genannten Adressierung von Displays ohne die große Zahl von elektrischen Verbindungen auszukommen.

Zur Lösung dieser Aufgabe wird eine Anordnung nach dem Oberbegriff des Anspruches 1 vorgeschlagen, die erfindungsgemäß die im kennzeichnenden Teil des Anspruches 1 genannten Merkmale hat.

. . .

Vorteilhafte Weiterentwicklungen der Erfindung sind in den Unteransprüchen genannt.

Hinsichtlich der eingangs genannten Adressierung von Displays wird durch die Erfindung eine neue Adressiertechnik geschaffen, bei der nur zwei Verbindungen für die Adressierung notwendig sind. Außerdem können stillstehende Bilder mit Flüssigkristallen ohne innewohnenden Speichereffekt erzeugt werden, und das Display kann auch zur Digitalisierung der Bewegung beispielsweise eines optischen Schreibstiftes verwendet werden. Das Display kann auch für Messungen verwendet werden, wobei das Display wie eine Fotodiode oder CCD-Matrize arbeitet.

Wichtigster elementarer Teil der Erfindung sind die elektrooptisch rückgekoppelten Speicherelemente, die zu Schieberegistern in Reihe geschaltet werden können. Das Schieberegister kann aus Fotowiderstandelementen oder Fotodioden aufgebaut sein, die mit beispielsweise Dünnfilmtechnologie zusammen mit einer elektrischen Leiteranordnung auf einem Substrat, z.B. einer großen Glasplatte, integriert werden. Bei den optischen Modulatoren, die Anlaß zu der elektrooptischen Rückkopplung geben, kann es sich beispielsweise um Flüssigkristalle handeln, die zwischen das Substrat und einer Deckscheibe aus beispielsweise Glas liegen, die auf der Innenseite mit einer lichtpolarisierenden Schicht und einem transparenten Film belegt sind. Das Schieberegister kann elektrisch und/oder optisch gesteuert werden. Im letztgenannten Fall wird die Information zwischen den Speicherzellen im Schieberegister dadurch verschoben, daß zwei oder mehrere Leucht- oder Laserdioden mit verschiedenen Emissionswellenlängen in einer bestimmten Reihenfolge eingeschaltet werden, wodurch man eine einphasige, zweiphasige oder dreiphasige optische Steuerung erhalten kann.

Die Erfindung betrifft eine neue Anordnungsart, mit der in

...

- 3 -

erster Linie optische Displays moduliert und optische Digitizer abgetastet werden können. Mit den in der Erfindung
beschriebenen Anordnungen können elektrische Informationen
seriell oder parallel in einen ein- oder zweidimensionalen
optischen Modulator eingespeist werden, der bei Displayanwendungen die Aufgabe hat, Bildinformation an den Betrachter zu geben. Zur Informationsübertragung vom Menschen
zur Maschine kann ein optischer Schreibstift verwendet werden, der dem optischen Modulator optische Informationen
zuführt, die auf elektrooptischem Wege elektrisch in
serieller oder paralleler Form abgelesen werden können.

Die Anordnungen, welche die Erfindung umfaßt, basieren auf
elektrooptischen Kreisen, die in verschiedener Weise mit optischen Modulatoren integriert werden können. In einigen
Fällen können auch die optischen Modulatoren, die als aktive Elemente in die elektrooptischen Kreise eingehen, zur
Lichtmodulation in beispielsweise einem Display verwendet
werden.

Zum näheren Verständnis soll die Erfindung anhand von Ausführungsbeispielen erläutert werden. Es zeigen

Figur 1 - 8     elektrooptische Grundelemente gemäß der
                Erfindung, die durch verschiedene Kombinationen zum Aufbau der für die Erfindung
                wichtigen elektrooptischen Kreise verwendet werden können,
Figur 9 - 23    Beispiele solcher aus den Grundelementen
                aufgebauten elektrooptischen Kreise.

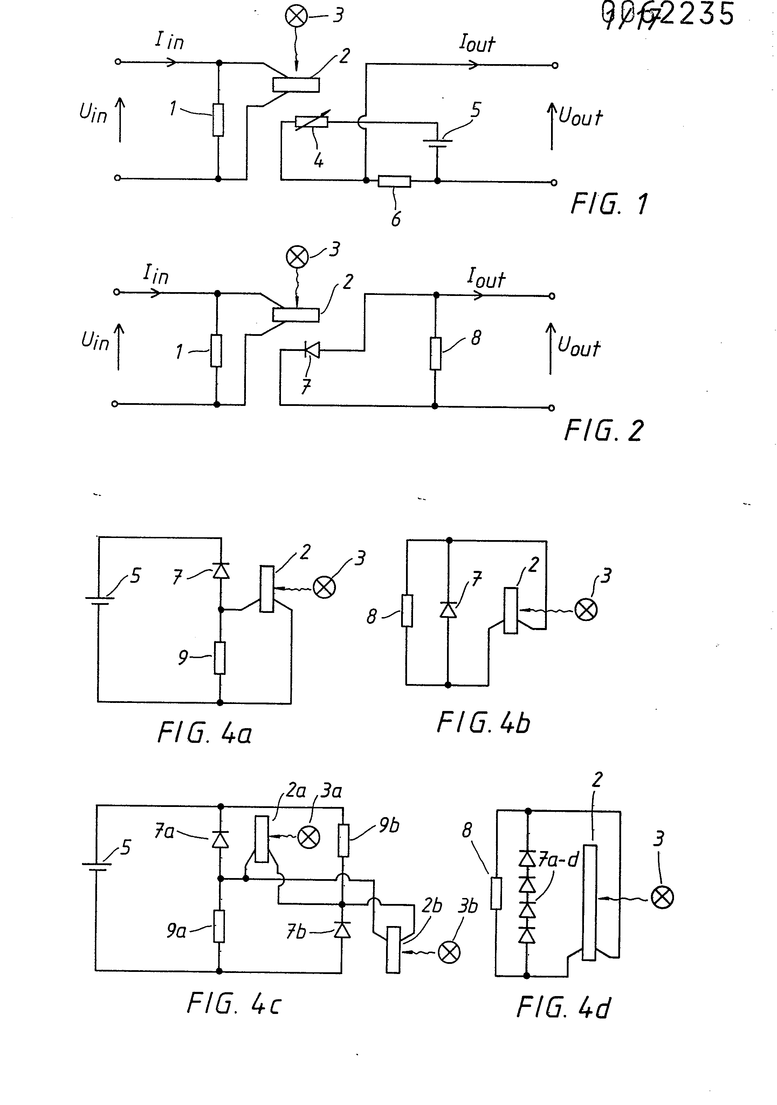

Figur 1 zeigt eine elektrooptische Grundschaltung mit einem
optischen Modulator 2 und einem Fotodetektor 4. Der optische
Modulator kann unterschiedlicher Art sein. Beispielsweise
kann es sich handeln um einen Flüssigkristall, eine Kerr-
Zelle, ein elektrisch gesteuertes Fabry-Perrot-Filter, ein
elektrisch gesteuertes doppelbrechendes Filter, ein Franz-Keldysh-Modulator oder einen elektrostatischen Lichtmodulator. Die Funktion des Modulators 2 besteht darin, das
Licht von der Lichtquelle 3 so zu modulieren, daß man mit
der Spannung $U_{in}$ die Leistung des Lichtes steuern kann, das
den Fotodetektor 4 erreicht. Der Fotodetektor 4, der ein
Fotowiderstand ist, liegt in einem elektrischen Kreis, der
aus der Spannungsquelle 5 und dem festen Widerstand 6 besteht. Am Widerstand 6 kann eine Ausgangsspannung $U_{out}$
abgegriffen werden. Der Widerstand 1 beschreibt den Eingangswiderstand des Modulators 2. Wenn der Modulator 2 beispielsweise ein Flüssigkristall ist, so erhält man einen
hohen Eingangswiderstand für den Kreis, und gleichzeitig
kann der Ausgangswiderstand verhältnismäßig niederohmig gewählt werden. Zwischen dem Eingang und dem Ausgang des
elektrooptischen Kreises gemäß Figur 1 erhält man eine Übertragungscharakteristik (Spannungsverstärkung, Stromverstärkung, Impedanzumwandlung usw.), die mit einem Feldeffekttransistor verglichen werden kann. Hierdurch wird es im
Prinzip möglich, mit Hilfe von EO-Kreisen (elektrooptischen
Kreisen) nach Figur 1 Verstärker, aktive elektronische Filter, Oszillatoren, nichtlineare Glieder, Schalter, logische Schaltkreise, Verzögerungselemente, Kippstufen,
Schieberegister, Speicher usw. aufzubauen. Die Erfindung
bezieht sich insbesondere auf Anordnungen für elektrooptische Schieberegister und Speicher, die zur Adressierung
und/oder Modulation von Licht in ein- oder zweidimensionalen
Modulatoren und zur Abtastung und/oder Auslesung in Digitizern verwendet werden können.

Durch Verwendung anderer Arten von Fotodetektoren als Fotowiderstände (Fotoleiter), wie z.B. Fotodioden, Fototransistoren, Fotozellen, Fotomultiplikatoren, Foto-Feldeffekttransistoren oder Fotokapazitäten kann eine andere Übertragungscharakteristik erreicht werden. Einen für die Erfindung wichtigen Kreis mit einer Fotodiode zeigt Figur 2.
Die Eingangsstufe ist die gleiche wie in Figur 1, doch
besteht die Ausgangsstufe in diesem Fall aus einer Foto-

...

diode 7, wodurch auf die Spannungsquelle verzichtet werden kann. Im Prinzip arbeitet der Kreis nach Figur 2 wie ein Spannungs-/Strom-Wandler, bei dem der Verstärkungsgrad durch die Lichtintensität der Lichtquelle 3 gesteuert werden kann.

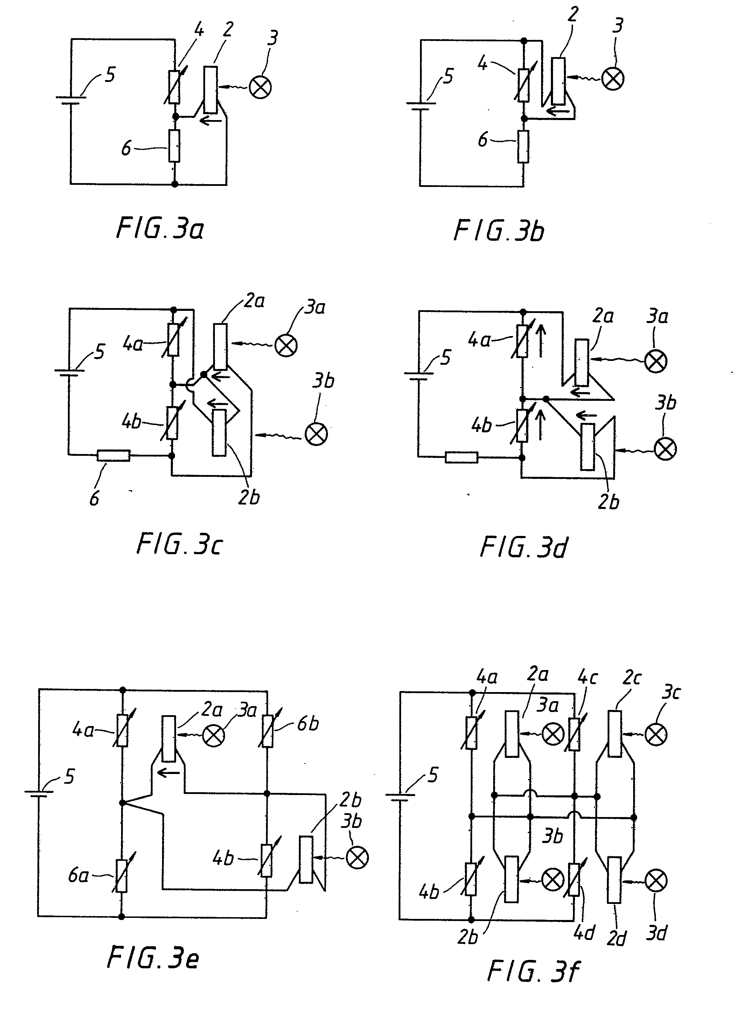

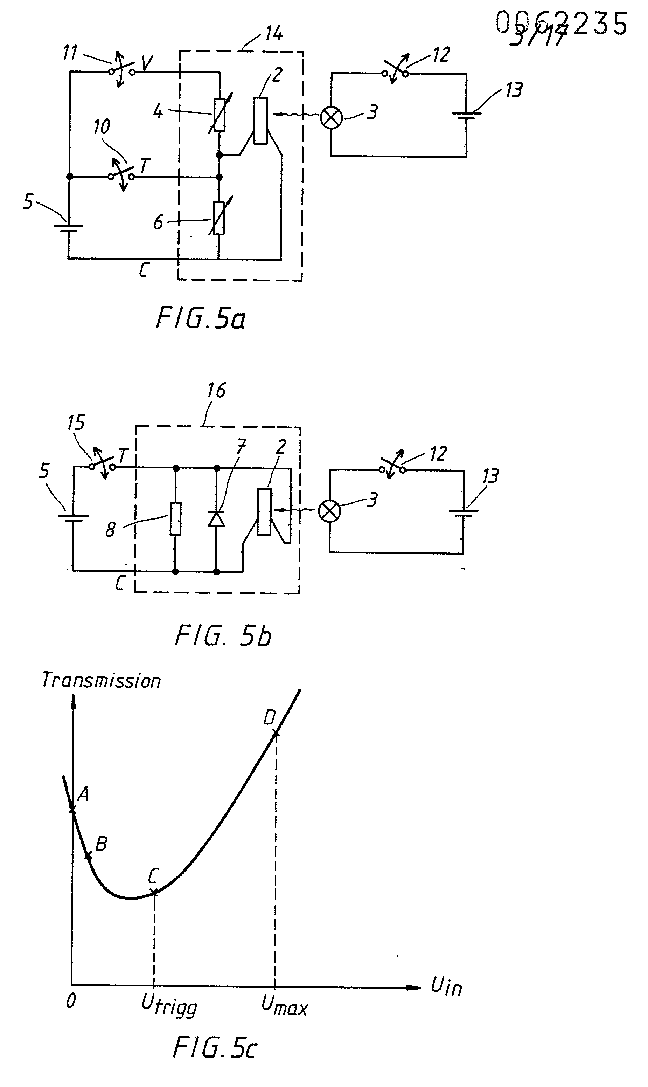

Für die Schieberegister und Speicher, welche die Erfindung behandelt, ist die Möglichkeit, mit den elektrooptischen Kreisen gemäß Figur 1 und 2 elektrooptische Rückkopplungen vornehmen zu können, von entscheidender Bedeutung. Figur 3 zeigt sechs verschiedene Beispiele für elektrooptische Rückkopplung mit Fotowiderständen, während Figur 4 vier verschiedene Beispiele für elektrooptische Rückkopplung mit Fotodioden zeigt.

In Figur 3a ist der Eingangsteil des Kreises aus Figur 1 einfach an den Ausgang des Kreises geschaltet. Für Figur 3b gilt das Gleiche, jedoch mit dem Unterschied, daß die Spannung am Widerstand den Ausgang bildet. Wenn eine erhöhte Spannung am optischen Modulator 2 eine geringere Lichtdämpfung und somit eine stärkere Beleuchtung des Fotowiderstandes 4 bewirkt, wodurch dessen Widerstand verkleinert wird, so erhält man in Figur 3a eine positive Rückkopplung und in Figur 3b eine negative Rückkopplung. In den Schaltungen nach Figur 3c und 3d ist ein weiterer Fotowiderstand 4b vorhanden, der mit einem weiteren optischen Modulator 2b versehen ist. Dadurch, daß die Modulatoren kreuzgeschaltet sind, kann man stärkere nichtlineare Zusammenhänge erzeugen, was jedoch gemäß Figur 4b nicht erforderlich ist. Negative Rückkopplungen kann man durch Umpolung des Modulators 2 erzielen. Figur 4c zeigt ein Beispiel einer Brückenschaltung mit Fotodioden, und Figur 4d zeigt die Möglichkeit, Fotodioden in Reihe zu schalten, um die Modulationsspannung für den Modulator 2 zu erhöhen. 7, 7a bis 7d sind Fotodioden, 8, 9, 9a bis 9b sind feste Widerstände, 2, 2a bis 2b sind optische Modulatoren und 3, 3a bis 3b sind Lichtquellen.

. . .

Mit Hilfe der elektrooptischen Rückkopplungen gemäß Figur 3 und 4 können verschiedene Arten von Speicherelementen und Kippstufen aufgebaut werden. Figur 5a zeigt ein einfaches Speicherelement mit einem Fotowiderstand. Mit Hilfe des Schalters 10 wird das Element aktiviert, und mit Hilfe der Schalter 11 oder 12 wird das Element auf Null gestellt. Es wird angenommen, daß die Lichtquelle 3 deshalb leuchtet, weil der Schalter 12 geschlossen und die Spannungsquelle 13 somit an der Lichtquelle 3 liegt. Wenn beide Schalter 10 und 11 offen sind, ist am Widerstand 6 keine Spannung vorhanden und wenn der elektrooptische Modulator eine Charakteristik gemäß Figur 5c hat, was z.B. mit Flüssigkristallen erreichbar ist, befinden wir uns im Punkt A der Transmissionskurve in Figur 5c. Wenn der Schalter 11 geschlossen wird, steigt die Spannung $U_{in}$ am Widerstand 6 an, wodurch gemäß Figur 5c die Lichttransmission durch den Modulator 2 verringert wird, und folglich der Widerstandswert des Fotowiderstandes 4 erhöht und $U_{in}$ verringert wird, was eine negative Rückkopplung bedeutet, die dem Modulator einen Transmissionwert gibt, welche dem Punkt B der Kurve in Figur 5c entspricht. Dieser Lage wird eine logische Null zugeordnet. Wenn der Schalter 11 nun für einen kurzen Augenblick geschlossen wird, so daß die Spannung am Modulator 2 den Wert $U_{trigg}$ zu überschreiten gezwungen wird, dann ändert sich die Rückkopplung von einer negativen in eine positive, und die Spannung $U_{in}$ steigt schnell auf ihren oberen Höchstwert $U_{max}$. Dieser Lage wird eine logische Eins zugeordnet. Wird dann der Schalter 11 oder 12 für einen kurzen Augenblick geöffnet, so rutscht der Arbeitspunkt auf der Transmissionskurve schnell wieder in die Lage B, in der er so lange liegen bleibt, bis der Schalter 10 wieder kurzfristig geschlossen wird. Die Schaltung nach Figur 5a stellt also ein logisches Speicherelement dar.

Figur 5b zeigt ein entsprechendes Speicherelement, das statt mit einem Fotowiderstand mit einer Fotodiode arbeitet. Über den Schalter 15 wird eine ausreichend hohe Spannung

. . .

an den Modulator 2 gelegt, damit dessen Arbeitspunkt auf den ansteigenden Ast der Kennlinie (rechts von C in Figur 5c) gelangt. Das Speicherelement wird dadurch in die logische Lage 1 gestellt (Lage D in Figur 5c) und in dieser Lage durch die Spannung der Fotodiode 7 gehalten. Durch kurzes Öffnen des Schalters 12 wird das Speicherelement in die logische Lage 0 gestellt, indem der Arbeitspunkt des Modulators 2 in die Lage B in Figur 5c übergeht.

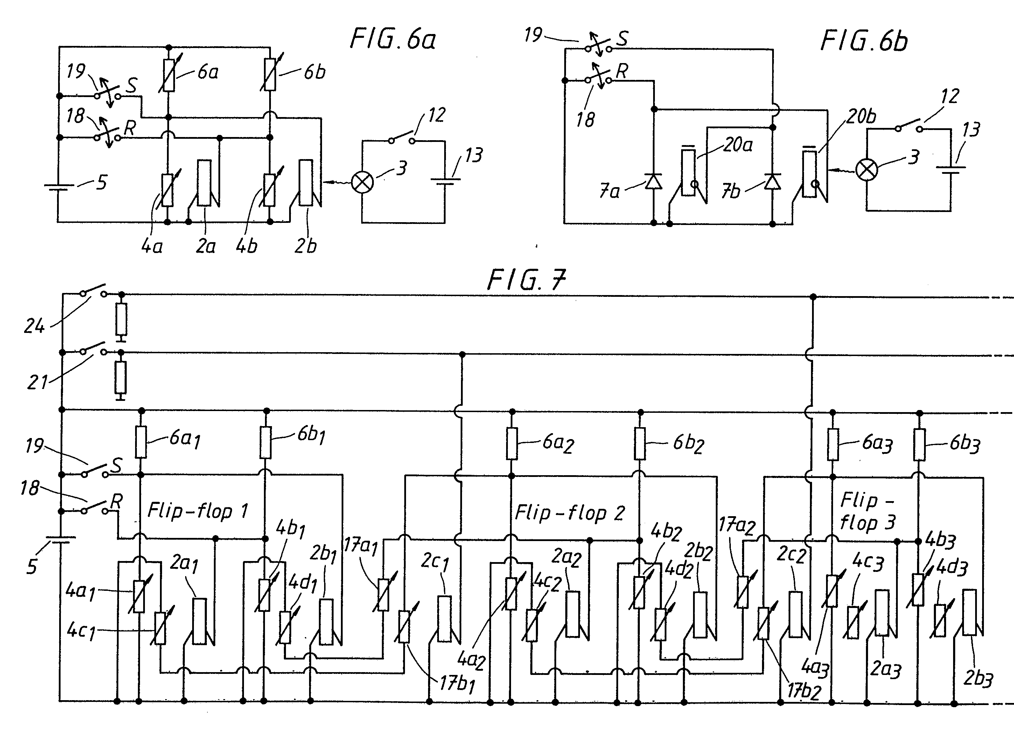

Die Speichereigenschaften der Elemente in Figur 5 erhält man durch zwei stabile Zustände der elektrooptischen Rückkopplungen, die durch eine Nichtlinearität in der Transmissionskurve des optischen Modulators verursacht wurden. Eine alternative Rückkopplungsmöglichkeit zur Gewinnung einer Speichereigenschaft ist die in Figur 6 gezeigte Kreuzschaltung, wobei die Schaltung in Figur 6a mit Fotowiderständen und die in Figur 6b mit Fotodioden arbeitet.

Wenn in Figur 6a die Schalter 12 und 19 geschlossen sind und der Schalter 18 offen ist, hat der Modulator 2b eine hohe Lichttransmission, der Fotowiderstand 4b einen niedrigen Widerstandswert, der Modulator 2a eine niedrige Spannung und geringe Transmission und der Fotowiderstand 4a einen hohen Widerstandswert. Wenn der Schalter 19 geöffnet wird, gibt der hohe Widerstand des Fotowiderstandes 4a eine beibehaltene hohe Spannung über dem Modulator 2b, und der Modulator 2b behält seine hohe Transmission und der Modulator 2a seine niedrige Transmission. Dieser Zustand kann so definiert werden, daß der Fotowiderstand 4b auf Null und der Fotowiderstand 4a auf Eins gestellt ist. Wenn nun der Schalter 18 kurz geschlossen wird, so wird der Fotowiderstand 4b auf Eins und der Fotowiderstand 4a auf Null gestellt. Man erhält somit eine elektrooptische SR-Kippstufe. Die Stabilität der Kippstufe in ihren beiden Lagen hängt von der gegenseitigen Anpassung (Matching) der Komponenten 2a, 4a und 2b, 4b (Verstärkungsfaktor, Nullpunktswert) sowie von der Nichtlinearität dieser Komponenten ab.

. . . .

Figur 6b zeigt eine elektrooptische SR-Kippstufe mit Fotodioden. Um negative elektrooptische Rückkopplungen zu erhalten, werden hier optische Modulatoren 20a und 20b mit negierter Charakteristik verwendet, was bedeutet, daß eine Erhöhung der Spannung am Modulator eine Senkung der Lichttransmission bewirkt. Ist der Schalter 12 geschlossen, und wird der Schalter 19 während einer kürzeren oder längeren Zeitspanne geschlossen, so ist die Spannung am Modulator 20a niedrig, die Lichttransmission durch den Modulator 20a groß, die Spannung an der Fotodiode 7a groß, die Spannung über dem Modulator 20b groß, die Lichttransmission durch den Modulator 20b niedrig, die Spannung an der Fotodiode 7b niedrig usw. Man kann also definieren, daß die Fotodiode 7a auf Eins und die Fotodiode 7b auf Null gestellt ist. Wenn stattdessen der Schalter 18 geschlossen wird, schlägt die SR-Kippstufe um, so daß die Fotodiode 7a auf Null und die Fotodiode 7b auf Eins gestellt wird.

Durch Kaskadenschaltung der SR-Kippstufen erhält man ein Schieberegister, welches in Figur 7 mit Fotowiderstandsschaltungen dargestellt ist. Wenn sämtliche optischen Modulatoren beleuchtet und die Schalter 21 und 24 offen sind, so arbeitet die erste SR-Kippstufe in der Weise, wie es anhand von Figur 6a beschrieben wurde. Es wird angenommen, daß der Schalter 19 den Fotowiderstand 4a1 auf Eins und damit den Fotowiderstand 4b1 auf Null gestellt hat. Wenn nun der Schalter 21 für einen Augenblick geschlossen wird, wird während der Zeit, während welcher der Schalter geschlossen ist, die Lichttransmission durch den Modulator 2c1 größer und der Widerstand der Fotowiderstände 17a1 und 17b1 kleiner. Hierdurch sinkt die Spannung am Fotowiderstand 4b2, da dieser Fotowiderstand zu den Fotowiderständen 17a1 und 4d1 parallelgeschaltet ist, welche durch die unter Spannung gesetzten Modulatoren 2c1 bzw. 2b1 beleuchtet werden. Somit ist sowohl die Kippstufe 1 (4a1) als auch die Kippstufe 2 (4a2) auf Eins gestellt. In der nächsten Phase kann durch Schließen des Schalters 18 die Kippstufe 1 auf Null gestellt wird. Danach kann der Schalter 24 für einen Augenblick geschlossen werden, wodurch die in der Kippstufe 2 gespeicherte logische Eins auf die Kippstufe 3 übertragen wird, die also auf Eins gestellt wird. Wenn dann der Schalter 21 wieder für einen kurzen Augenblick geschlossen wird, wird die Null von der Kippstufe 1 auf die Kippstufe 3 übertragen, und die ursprüngliche logische Eins ist also um drei Stufen nach rechts verschoben worden. Durch Verwendung von Trennstufen 17a1, 17b1, 2c1, 17a3, 17b3, 2c3 usw., die von dem Schalter 21 betätigt werden, und Trennstufen 17a2, 17b2, 2c2, 17a4, 17b4, 2c4 usw., die von dem Schalter 24 betätigt werden, können die Kippstufen bei der Informationsübertragung paarweise voneinander isoliert werden, wodurch die Gefahr einer Informationsdegradation erheblich geringer wird, als wenn die Trennstufen an ein und denselben Schalter angeschlossen wären. Man kann sagen, daß die Kippstufen in Figur 7 von zweiphasigen Steuerimpulsen gesteuert werden. Natürlich kann außer einer einphasigen oder zweiphasigen Steuerung auch eine dreiphasige Steuerung vorgenommen werden.

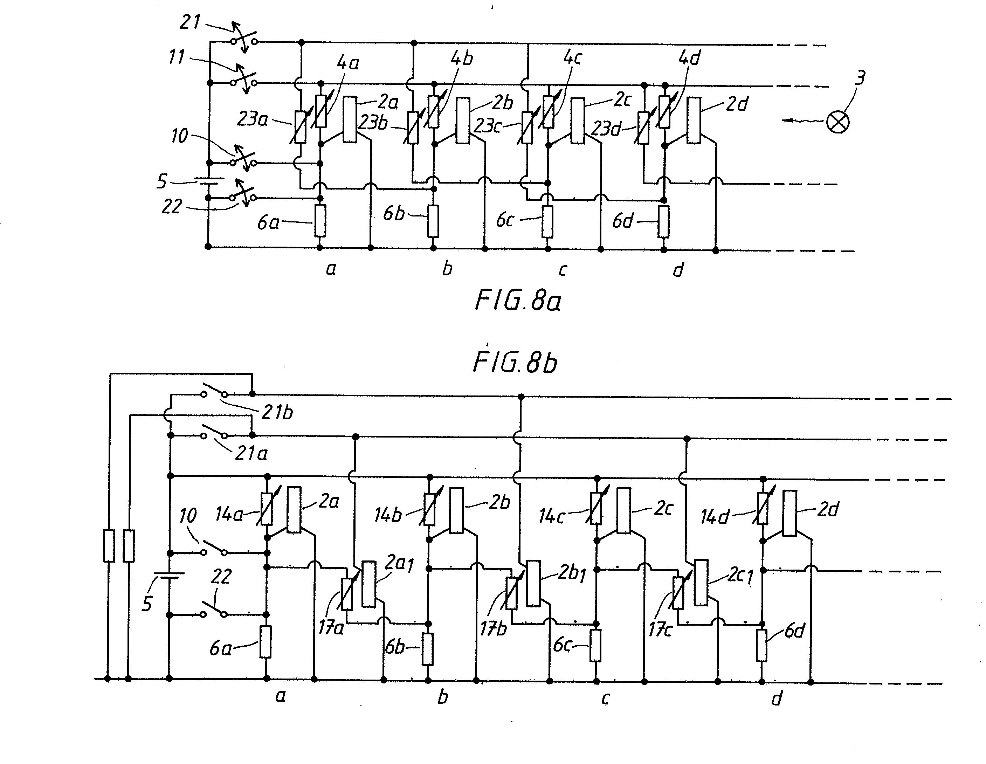

Wenn das Schieberegister aus Speicherelementen nach Figur 5a statt aus Kippstufen nach Figur 6a aufgebaut wird, so erhält man ein Schieberegister gemäß den Figuren 8, 9 und 10a bei Anwendung einer ein-, zwei- oder dreiphasigen Steuerung. Wenn in Figur 8a die Lichtquelle 3 die optischen Modulatoren 2a, 2b usw. beleuchtet, der Schalter 11 geschlossen ist und der Schalter 10 für einen kurzen Augenblick geschlossen wird, so hat - wie sich aus den Erläuterungen zu Figur 5a ergibt - der optische Modulator 2a eine große Lichttransmission, und die Fotowiderstände 4a und 23a haben kleine Widerstandswerte. Wenn dann der Schalter 21 für ein kurzes der Zeitkonstante der optischen Modulatoren entsprechendes Zeitintervall geschlossen wird, so gelangt ein Impuls an den Modulator 2b, der groß genug ist, das Speicherelement b auf Eins zu stellen. Durch wiederholte Betätigungen des Schalters 21 werden Einsen im Schieberegister schrittweise nach rechts verschoben. Um Nullen zu verschieben, ist ein Zusammenspiel zwischen den Schaltern 21 und 11 in der Weise erforderlich, daß zuerst Schalter 21 geschlossen wird, worauf Schalter 11 geöffnet, dann Schalter 11 geschlossen und dann Schalter 21 geöffnet wird. Dadurch stellt der Schalter 21 alle Elemente, die rechts von einem auf Eins gestellten Element liegen, auf Eins, während der Schalter 11 alle übrigen Elemente auf Null stellt.

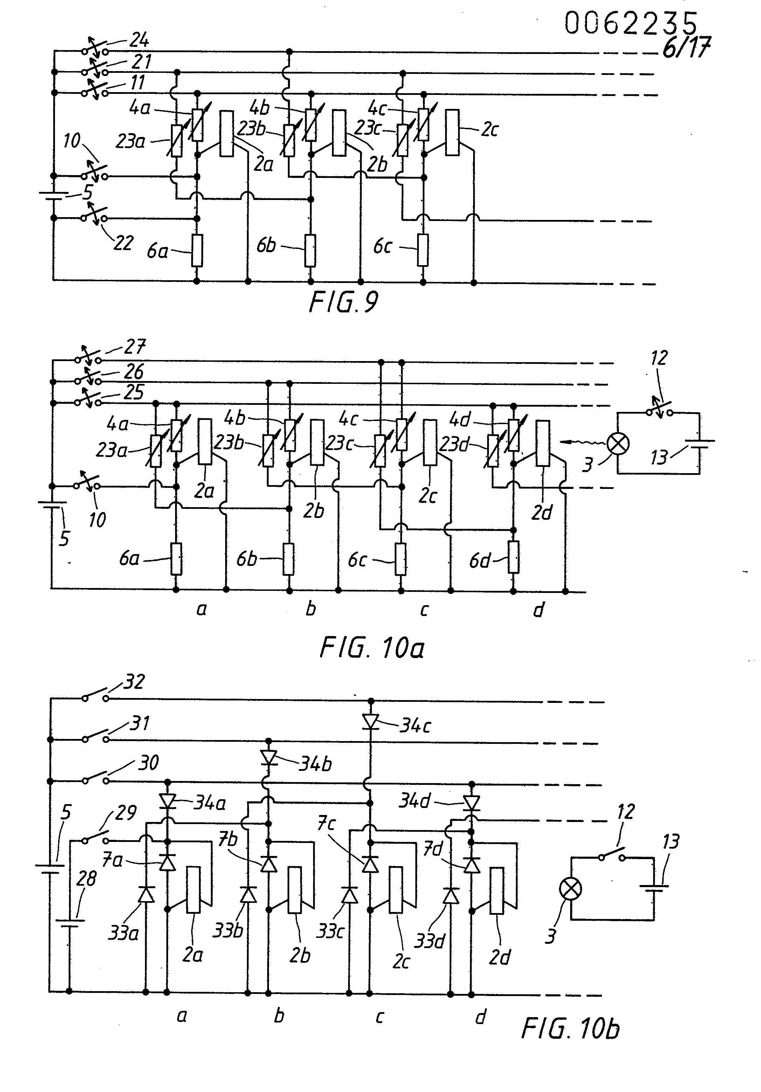

Figur 8b zeigt ein Schieberegister mit zweiphasiger Steuerung, bei welchem die Informationsübertragung zwischen den Speicherelementen mit Hilfe der anhand von Figur 7 beschriebenen elektrooptischen Trennstufen geschieht. Wenn das links von einer Trennstufe liegende Element auf Eins gestellt ist, so wird beim Schließen der Schalter 21a oder 21b das rechts liegende Element auf Eins gestellt, und wenn das links liegende Element auf Null gestellt ist, so wird das rechts liegende Element auf Null gestellt. Die Trennstufen sind aus optischen Modulatoren (2a1, 2b1 usw.), die an die Schalter 21a und 21b angeschlossen sind, sowie aus Fotowiderständen (17a, 17b, 17c usw.) aufgebaut, die zwischen den Verbindungspunkten der Widerstände 6 und 14 zweier benachbarter Elemente angeschlossen sind. Die Schalter 21a und 21b werden abwechselnd geschlossen (zweiphasige Steuerung), damit bei der Informationsübertragung zwischen den Speicherelementen diese paarweise isoliert werden. Figur 9 zeigt ein Schieberegister mit zweiphasiger Steuerung, das der Ausführung gemäß Figur 8a entspricht. Gegenüber der Schaltung in Figur 8a ist ein Schalter 24 hinzugekommen. Der Fotowiderstand 23 zur Informationsübertragung zwischen den Elementen ist für jedes zweite Element an den Schalter 21 angeschlossen und für die übrigen Elemente an den Schalter 24. Hierdurch erfolgt die Informationsübertragung innerhalb isolierter Paare, was die an die Steuerimpulszeit (die Zeit, während welcher die Schalter 21 und 24 geschlossen sind) gestellten Ansprüche herab-

...

setzt.

Um das Verschieben von Nullen nach dem in Figur 8a gezeigten Prinzip zu erleichtern, kann eine dreiphasige Steuerung gemäß Figur 10a angewendet werden. Die Speicherelemente sind in gleicher Weise wie die in Figur 8a aufgebaut und miteinander verbunden, doch haben die Fotowiderstände hier eine andere Speisung. Die Fotowiderstände 23a und 4a sind an den Schalter 25, die Fotowiderstände 23b und 4b an den Schalter 26, die Fotowiderstände 23c und 4c an den Schalter 27 und die Fotowiderstände 23d und 4d an den Schalter 25 angeschlossen usw., d.h. jedes dritte Speicherelement erhält denselben Steuerimpuls. Um eine Eins nach rechts zu verschieben, ist folgende Steuerimpulsfolge erforderlich: 25 wird geschlossen, 10 wird geschlossen, 10 wird geöffnet (a ist auf Eins gestellt), 26 wird geschlossen (b ist auf Eins gestellt), 25 wird geöffnet (b ist von a isoliert), 27 wird geschlossen (c ist auf Eins gestellt), 26 wird geöffnet (c ist von b isoliert), 25 wird geschlossen (a ist auf Null gestellt, d ist auf Eins gestellt) usw. Das ganze Schieberegister kann dadurch auf Null gestellt werden, daß sämtliche Schalter 25 bis 27 gleichzeitig geöffnet werden oder daß die Lichtquelle für einen Augenblick gelöscht wird.

Das Schieberegister kann auch aus Speicherelementen auf Fotodiodenbasis (Figur 5b) aufgebaut werden, wie dies Figur 10b zeigt. Die Speicherelemente können über die Steuerschalter 30 bis 32 und die Dioden 34a, b, c usw. auf Null gestellt werden, und die Informationsübertragung zwischen den Speicherelementen werden von den Fotodioden 33a, b, c usw. vorgenommen. Die Spannungsquelle 28 dient dazu, mit dem Schalter 29 das Speicherelement a bei der Informationseingabe auf Eins zu stellen. Die Schaltfolge für die Schalter 29 bis 32 beim Verschieben einer Eins durch das Register ist wie folgt:

...

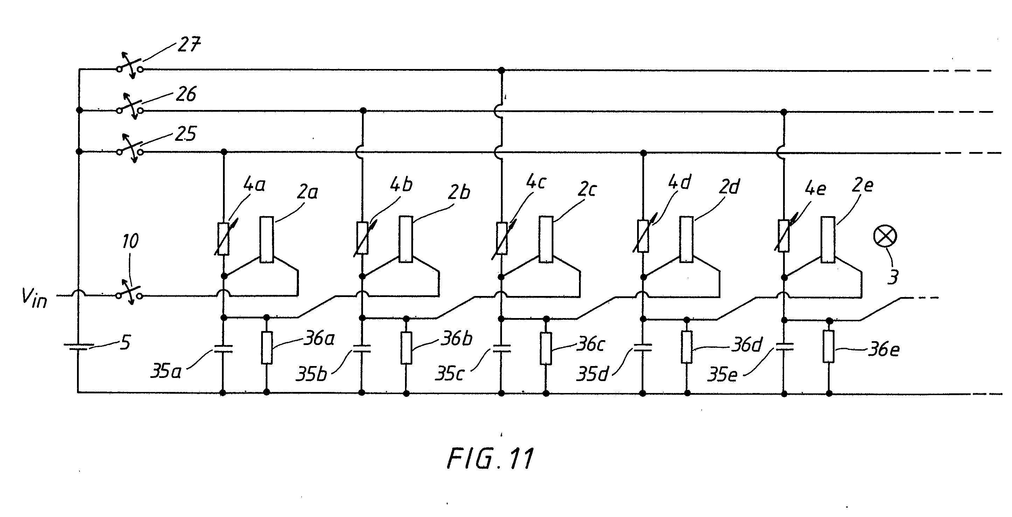

31 und 32 werden geschlossen (b und c sind auf Null gestellt), 30 wird offen gehalten, 29 wird geschlossen, 29 wird geöffnet (a ist auf Eins gestellt), 31 wird geöffnet (b wird von 33a auf Eins gestellt), 30 wird geschlossen (a wird auf Null gestellt), 32 wird geöffnet (c wird auf Eins gestellt), 31 wird geschlossen (b wird auf Null gestellt) usw. Die bisher beschriebenen Schieberegister sind für digitale Informationen und können abwechselnd Einsen und Nullen verschieben, welche zwei verschiedenen Lichttransmissionswerte der optischen Modulatoren entsprechen. Es besteht jedoch auch die Möglichkeit, analoge Information zu verschieben, was in Figur 11 veranschaulicht wird. Die analoge Information wird an den Kondensatoren 35a, b, c usw. aufgebaut, die einen gewissen Entladungswiderstand 36a, b, c usw. haben. Die folgende Schaltfolge kann verwendet werden:

10 wird geschlossen, 25 wird geschlossen (35a wird auf die Spannung $V_{in}$ aufgeladen), 26 wird geschlossen (35b wird auf die Spannung $V_{in}$ aufgeladen), 25 wird geöffnet, 27 wird geschlossen (35c erhält die Spannung $V_{in}$), 26 wird geöffnet, 10 wird geschlossen, 25 wird geschlossen, (35d erhält $V_{in}$, 35a erhält einen neuen Wert für $V_{in}$) usw. Die Kondensatoren 35 werden über die Fotowiderstände 4 aufgeladen, und wenn die Spannung an den Modulatoren 2 Null beträgt, hat die Transmission einen solchen Wert, daß der Strom über den Fotowiderstand 4a den über den Widerstand 36a fließenden Entladestrom ausgleicht. Wenn $V_{in}$ größer als die Spannung am Kondensator ist, ist die Lichttransmission größer als der vorher genannte Wert, und der Kondensator 35 wird aufgeladen. Wenn $V_{in}$ kleiner ist, wird der Kondensator über den Widerstand 36 entladen. Um die Degradation bei der Informationsübertragung zwischen den Speicherelementen zu verringern, können Trennstufen vorgesehen werden (siehe Figur 8b).

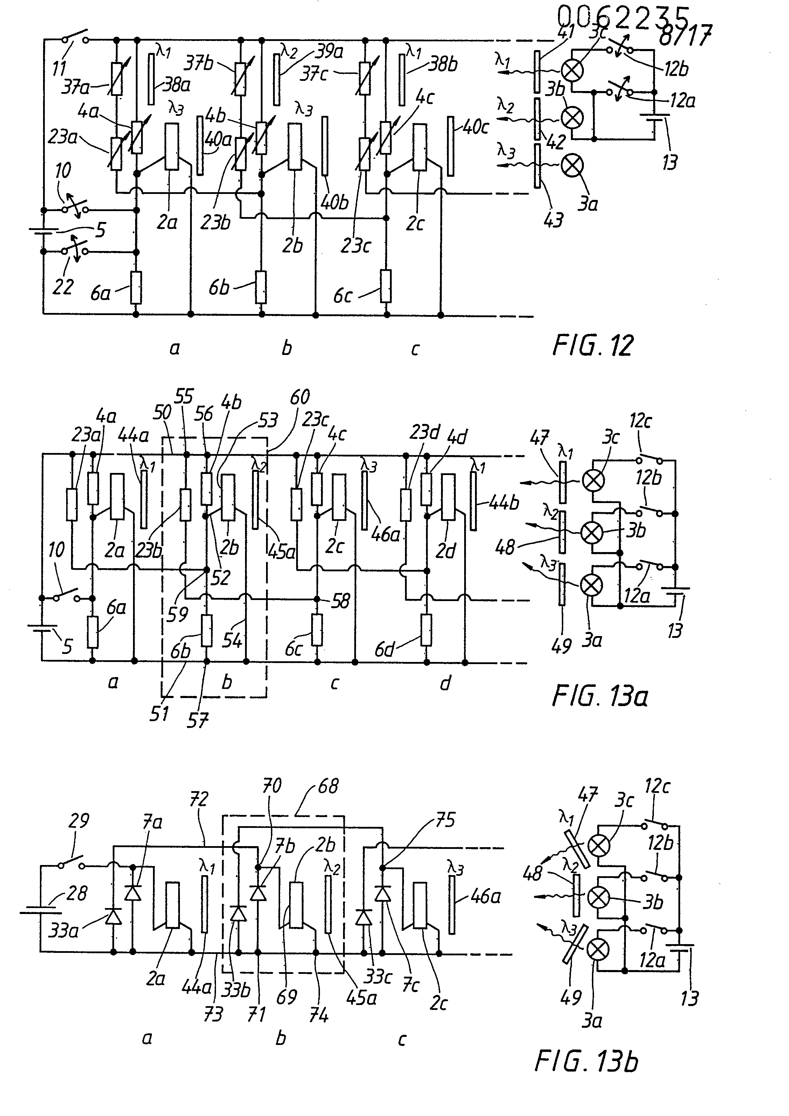

Eine Alternative gegenüber der Anwendung elektrischer Schalter 21, 24, 25, 26, 27, 30 usw. zur Steuerung der elektrooptischen Schieberegister ist eine optische Steuerung, die durch die Figuren 12 und 13 veranschaulicht wird. In dem einfachsten Fall können die elektrischen Schalter durch Fotowiderstände ersetzt werden, die durch Licht betätigt werden, was in Figur 12 für die zweiphasige Steuerung gezeigt ist (siehe Figur 9). Verglichen mit Figur 9 hat Figur 12 ein einfacheres elektrisches Leitungssystem, jedoch ein komplexeres optisches System. Bei der Verschiebung einer logischen Eins werden die Schalter 10, 12a und 12b in folgender Schaltfolge betätigt (es wird vorausgesetzt, daß die Lichtquelle 3a durch das optische Filter 43 und die optischen Filtern 40a, b, c usw. die Modulatoren 2a, b, c usw. kontinuierlich bestrahlt): 11 wird geschlossen, 10 wird für einen Augenblick geschlossen (a wird auf Eins gestellt), 12b wird für einen Augenblick geschlossen (b wird über 23a und 37a auf Eins gestellt). 23a wird von der Lichtquelle 3a über 43, 40a und 2a beleuchtet, und 37a wird von 3c über 41 und 38a beleuchtet, wenn 12b eingeschaltet ist), 12a wird für einen Augenblick geschlossen (c wird über 23b und 37b auf Eins gestellt, wobei 37b von 3b beleuchtet wird) usw.

Dadurch, daß die optischen Filter 38a, b, c usw. nur Licht durchlassen, das den Filter 41 passiert hat, die Filter 39a, b, c usw. nur Licht vom Filter 42 hindurchlassen und die Filter 40a, b, c, usw. nur Licht vom Filter 43 hindurchlassen, kann man die Fotowiderstände 37a, b, c optisch adressieren, wobei diese Fotowiderstände nicht durch Licht von der Lichtquelle 3a beeinflußt werden.

Wenn man von der Speicherelementschaltung in Figur 10a ausgeht, kann man ein dreiphasiges optisch gesteuertes Schieberegister gemäß Figur 13a erhalten. Die Verschiebung einer Eins geschieht hier auf folgende Weise:

12c wird geschlossen, 10 wird für einen Augenblick geschlossen (das Speicherelement a wird auf Eins gestellt, indem

...

Spannungsquelle 5 über 10 die Spannung an 6a erhöht und 3c über 47, 44a und den von 10 geöffneten Modulator 2a gleichzeitig 4a und 23a beleuchtet), 12b wird geschlossen (b wird auf Eins gestellt, da 3b über 48, 45a und 2b 4b beleuchtet), 12c wird geöffnet (a wird auf Null gestellt), 12a wird geschlossen (c wird auf Eins gestellt, da 3a über 49, 46a und 2c 4c beleuchtet), 12b wird geöffnet (b wird auf Null gestellt), 12c wird geschlossen (d wird auf Eins gestellt und gleichzeitig wird eine Eins in a eingegeben, wenn 10 geschlossen ist, andernfalls eine Null) usw.

Optische Steuerung kann vorzugsweise auch für Speicherelemente mit Fotodioden (Figur 5b) verwendet werden, was in Figur 13b gezeigt ist. Eine Eins wird auf die folgende Weise verschoben:

12c wird geschlossen und 29 wird für einen Augenblick geschlossen (a wird dadurch auf Eins gestellt, daß Schalter 29 das Element a aktiviert, und 3c über die Komponenten 47, 44a und 2a einen Fotostrom durch 7a erzeugt, der 2a auch dann geöffnet hält, wenn 29 nicht mehr geschlossen ist), 12b wird geschlossen (b wird vom Fotostrom von 33a auf Eins gestellt und von 7b, die von 3b über 48, 45a und 2b beleuchtet wird, auf Eins gehalten), 12c wird geöffnet (a wird auf Null gestellt), 12a wird geschlossen (c wird von 33b auf Eins gestellt), 12b wird geöffnet (b wird auf Null gestellt) usw. Auch hier gilt, daß 3c nur 2a, d, g usw., 3b nur 2b, e, h usw. und 3a nur 2c, f, i usw. beleuchten kann. Dies kann dadurch erreicht werden, daß beispielsweise optische Bandpaßfilter mit verschiedenen Mittelwellenlängen $\lambda_1$, $\lambda_2$ und $\lambda_3$ verwendet werden.

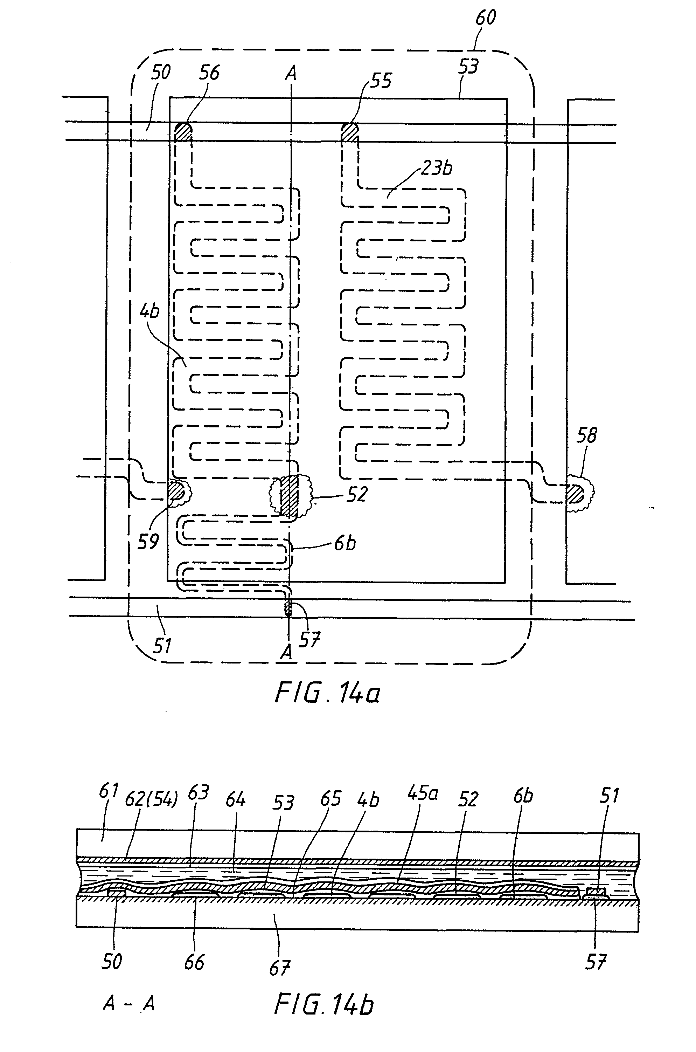

Figur 14 zeigt, wie das Speicherelement b in Figur 13a verwirklicht werden kann, wenn es sich bei den optischen Modulatoren um einen Flüssigkristall handelt. Figur 14b zeigt das Element im Schnitt längs der Schnittlinie A - A in Figur 14a. Mit bekannter Technologie für integrierte Dick- und Dünnfilmkreise und integrierte Halbleiterkreise wird ein

. . .

Substrat 67 mit einer reflektierenden Schicht 66, Fotowiderstandsmaterial 4b, lichtpolarisierendem Isolatormaterial 65,
elektrisch leitenden Schichten 50, 51, Widerstandsmaterial
6b, einer transparenten elektrisch leitenden Schicht 53 und
einer Interferenzfilterschicht 45a belegt. Zwischen dem
Grundsubstrat 67 und einer transparenten Scheibe 61, die auf
der Unterseite mit einer transparenten, elektrisch leitenden Schicht 62 und einer lichtpolarisierenden Schicht 63
belegt ist, wird der Flüssigkristall 64 angebracht. Um die
Transmissionscharakteristik gemäß Figur 5c zu erhalten,
wird die Polarisationsrichtung des Flüssigkristalls 64 relativ zur Polarisationsrichtung der polarisierenden Schichten 63 und 65 so gewählt, daß die Spannung 0 zwischen den
Schichten 62 und 53 eine gewisse Lichttransmission bewirkt,
während eine etwas höhere Spannung an der Schicht 53 eine
geringere Transmission bewirkt. Wenn die Spannung an der
Schicht 53 jedoch über einen bestimmten Wert erhöht wird,
wird die Transmission wieder größer. Die geringste Transmission kann darauf beruhen, daß die Polarisationsrichtung
des Lichtes, das den Kristall 64 passiert, und die Polarisationsrichtung des Isoliermaterials 65 um 90° verschieden
sind. Die Feineinstellung der Lage der Arbeitspunkte auf
der Transmissionskurve nach Figur 5c kann dadurch geschehen,
daß man an die Schicht 62 eine geeignete Vorspannung legt.

Die einzelnen elektrischen Komponenten im Speicherelement
b in Figur 13a können einfach anhand von Figur 14a und zum
gewissen Teil anhand von Figur 14b identifiziert werden.
Die elektrische Speisung geschieht durch die leitenden
Streifen 50 und 51, die in den Punkten 55, 56 und 57 an die
Widerstände 23b, 4b bzw. 6b angeschlossen sind. Der elektrische Kontakt dieser Anschlüsse kommt dadurch zustande,
daß keine isolierende Schicht 65 vorhanden ist. Dieselbe
Technik wird angewendet, um im Punkte 52 den Ausschluß von
4b und 6b an die Flüssigkristallelektrode 53 und im Punkte
58 den Widerstand 23b an die Elektrode des nächsten Speicherelementes, entsprechend Punkt 59 im Speicherelement b,

...

- 16 -

anzuschließen. Natürlich bestehen viele Möglichkeiten, den
Aufbau zu variieren, doch ist es von großer Bedeutung, daß
der Aufbau gemäß Figur 14 keine sich kreuzenden Leiter,
Widerstände oder Fotowiderstände erfordert.

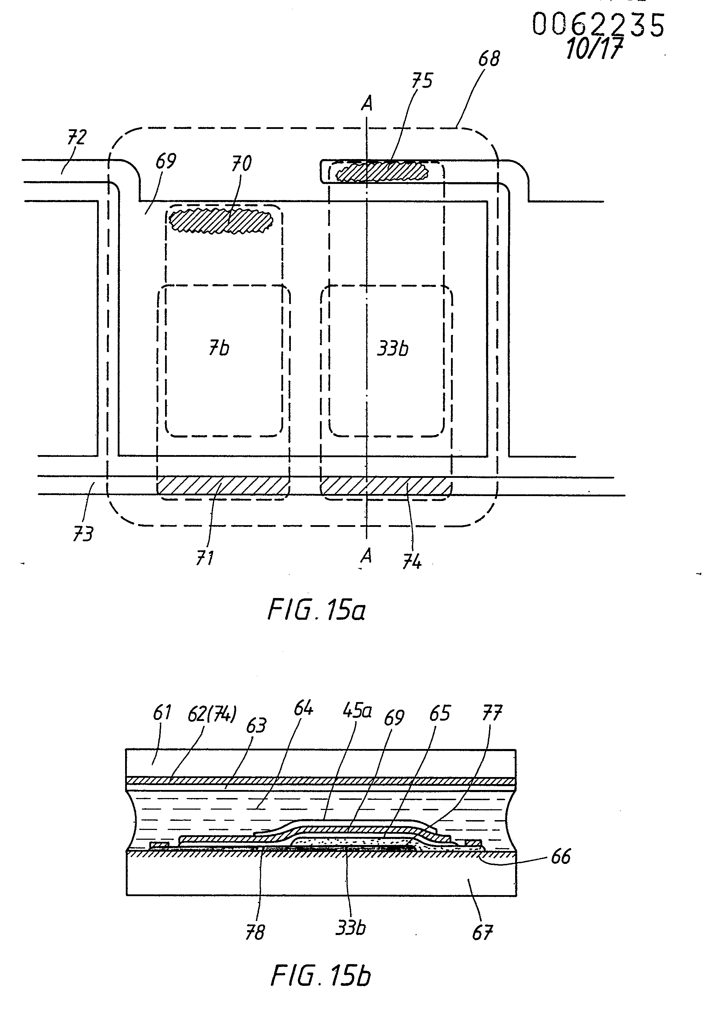

Figur 15 zeigt ein Beispiel für die Herstellung eines Speicherelementes, das mit Fotodioden gemäß Figur 13b aufgebaut
ist. Die Fotodioden bestehen aus einer p-Schicht 77 und einer n-Schicht 78. Die Fotodiode 7b ist im Punkte 70 an die
Elektrode 69 und im Punkte 71 an den Leiter 73 angeschlossen. Die Fotodiode 33b ist im Punkte 75 an die Elektrode
des nächsten Speicherelementes und im Punkte 74 an den Leiter 73 durch einen elektrisch leitenden Arm 72. Die verschiedenen Schichten im Speicherelement zeigt Figur 15b,
die einen Schnitt längs der Linie A - A in Figur 15a darstellt. Das Grundsubstrat 67 ist mit einer reflektierenden
Schicht 66, n-leitendes Halbleitermaterial 78, p-leitendes
Halbleitermaterial 77, lichtpolarisierendem Isoliermaterial
65, einem transparenten elektrischen Leiter 69, einem Interferenzfilter 45a, einem Flüssigkristall 64, einer lichtpolarisierenden Schicht 63, einen transparenten elektrischen Leiter 62 und einer transparenten Scheibe 61 belegt. Das Element wird von der oberen Seite beleuchtet.
Wenn es sich bei dem Substrat 67 um Halbleitermaterial
handelt, kann das Fotodiodenelement entsprechend bekannter Technologie hergestellt werden.

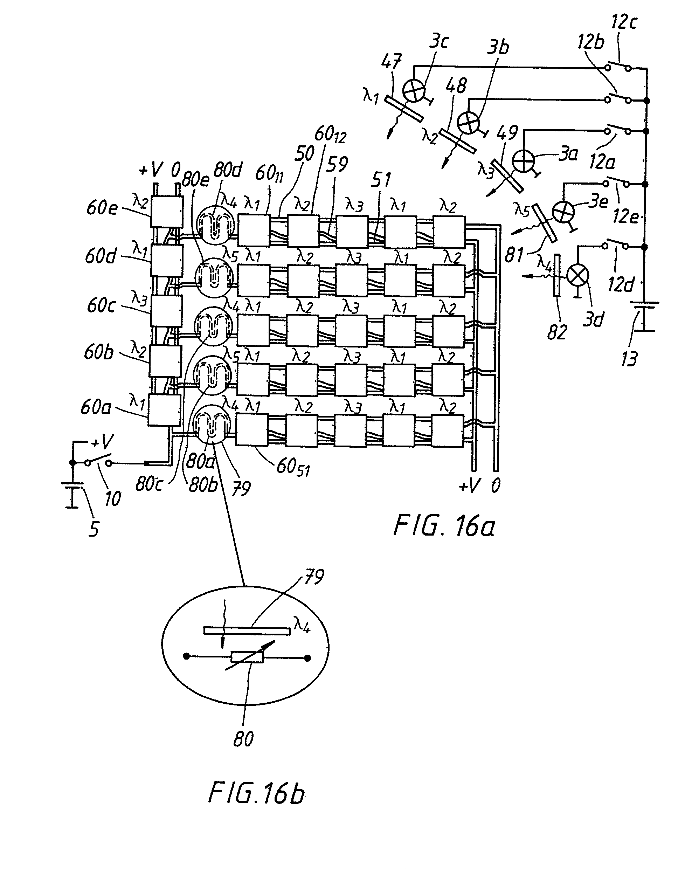

Mit Hilfe von Schieberegistern, die gemäß den anhand der
Figuren 7, 8, 9, 10, 11, 12, 13, 14, und 15 beschriebenen
Prinzipien aufgebaut sind, können elektronisch modulierbare Displays aufgebaut werden, was in den Figuren 16 und
17 veranschaulicht ist, die zweidimensionale Displays mit
Speicherelementen gemäß Figur 13a und Figur 14 zeigen.
Mit dem Schalter 10 kann das Speicherelement 60a bei der
Informationseingabe auf Eins gestellt werden, und mit den
Schaltern 12a, b und c kann die Information im Schieberegister mit den Speicherzellen 60a, b, c, d und e wei-

...

- 17 -

tergeschoben werden. $\lambda_1$, $\lambda_2$ und $\lambda_3$ definieren die Mittelwellenlängen für die Interferenzfilter in den Speicherelementen und vor den Lichtquellen. Durch die Speicherzellen 60a - 60e wird Information an die horizontalen Schieberegister, die das Display darstellen, weitergegeben. Die Informationsübertragung von dem vertikalen Schieberegister zu den horizontalen Schieberegistern geschieht über die Fotowiderstände 80a - 80d, die mit den Interferenzfiltern 79a - 79d mit den Mittelwellenlängen $\lambda_4$ und $\lambda_5$ versehen sind, und zwar abwechselnd jedes zweite mit $\lambda_4$ bzw. $\lambda_5$. Da die Filter 81 und 82 vor den Lichtquellen 3d und 3e die Mittelwellenlängen $\lambda_4$ bzw. $\lambda_5$ haben, können die Schalter 12d und 12e dazu benutzt werden, die Information in das Display hineinzusteuern. Die Fotowiderstände 80 (Figur 16b) sind zwischen die Punkte 58 (Figur 14a) der Elemente in dem vertikalen Schieberegister und dem Punkt 59 des jeweiligen ersten Elementes in den horizontalen Schieberegistern geschaltet. Wenn $\lambda_1$, $\lambda_2$ und $\lambda_3$ für die drei Hauptfarben gewählt werden, kann man durch geeignete Wahl der Schaltfolge eine gewisse Farbwiedergabe erreichen. Bei dreiphasiger Steuerung kann die Größe der Speicherelemente der Informationsdichte derart angepaßt werden, daß einem großen Displayelement zwei kleine Speicherelemente folgen, bevor das nächste große Displayelement im Schieberegister folgt. Wenn beide Platten 61 und 67 in Figur 14b transparent sind, kann das Display durchsichtig ausgeführt werden, wodurch die Lichtquellen 3a - 3e vom Betrachter aus gesehen hinter dem Display angeordnet sind.

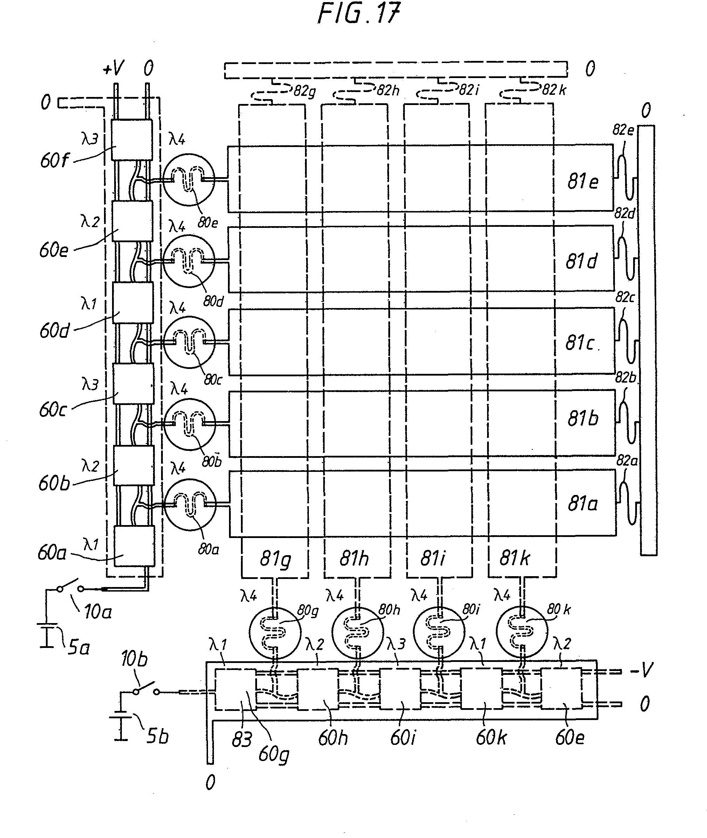

Das Schieberegister 60a - 60e in Figur 16 kann als ein y-Adressenregister betrachtet werden. Figur 17 zeigt, wie man eine xy-Adressierung vornehmen kann, indem man die Platte 67 (Figur 14b) mit einem Schieberegister 6a - f versieht, das an die horizontalen Elektroden 81a - e angeschlossen ist, und die Platte 61 mit einem anderen Schieberegister 60g - 60l versieht, das an die vertikalen Elektroden 81g - k angeschlossen ist. Wenn die beiden Platten 61

...

und 67 zusammengelegt werden, bildet der Flüssigkristall einen optischen Modulator sowohl für die Speicherelemente 60a - 1 als auch für das Display, der von der Spannung zwischen den transparenten Elektroden 81a - e und 81g - k gesteuert wird. Das Schieberegister 61a - f wird von Lichtquellen gesteuert, die in einem Paneel auf der Oberseite der Platten 61, 67 angeordnet sind, und das Schieberegister 60g - 1 wird von Lichtquellen gesteuert, die unter den Platten 61, 67 angeordnet sind. Die Fotowiderstände 80a - k dienen zur Ablesung des Spannungszustandes der Speicherelemente der Schieberegister zwischen den Steuerzyklen. Die Widerstände 82a - k und 80a - k sind so gewählt, daß der Flüssigkristall, wenn z.B. die Speicherelemente 60d und 60h auf Eins gestellt sind, im Kreuzpunkt zwischen 81d und 81h einen von der Umgebung abweichenden Transmissionszustand annimmt. Wenn der Flüssigkristall einen verwendbaren Hystereseneffekt besitzt, können mit der Schaltung nach Figur 17 durch geeignete Schaltfolgen für die Lichtquellen 10a, b stillstehende  Bilder in das Display einprogrammiert werden. Wenn der Flüssigkristall keinen Speichereffekt besitzt, kann die übliche Absuchtechnik (scanning-Technik) angewandt werden.

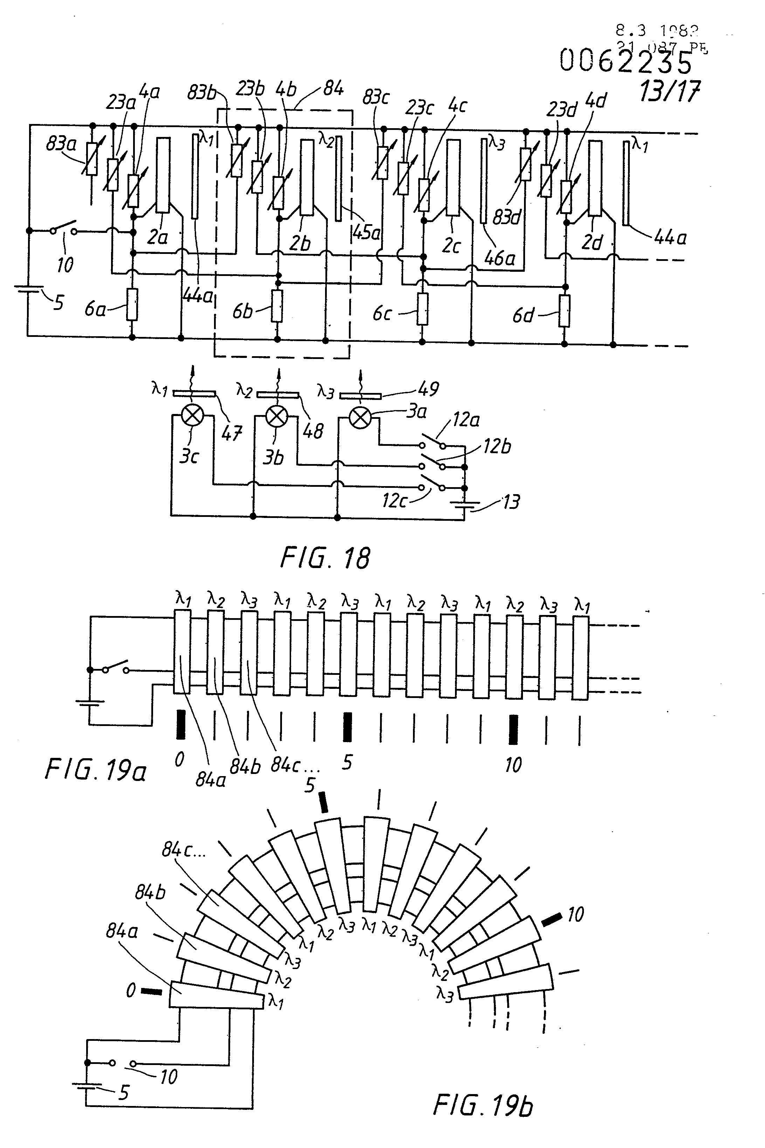

In vielen Zusammenhängen mit Displays kann ein Schieberegister, in dem die Information in beiden Richtungen verschoben werden kann, die Displayfunktionen erweitern. Figur 18 zeigt, wie das Schieberegister in Figur 13a für reversiblen Betrieb ergänzt werden kann. Gegenüber Figur 13a ist nur ein Fotowiderstand 83 pro Speicherelement hinzugekommen. Mit diesem Widerstand kann die Information zu dem vorhergehenden Speicherelement zurückgeschoben werden, indem die Lichtquellen mit umgekehrter Folge gesteuert werden.

Mit reversiblen Schieberegistern können einfache linear- und kreisförmig angeordnete Displays zu Anzeigezwecken gemäß Figur 19 verwendet werden. Logische Einsen werden vom Schalter 10 nach rechts geschoben, wenn der anzuzeigende

...

- 19 -

Wert steigt und wieder nach links zurückgeschoben, wenn der anzuzeigende Wert sinkt. 84a, b, c usw. beziehen sich auf das Speicherelement 84 in Figur 18, und $\lambda_1$, $\lambda_2$ und $\lambda_3$ beziehen sich auf die Mittelwellenlängen der Interferenzfilter 44a, b, c, 45a, b, c und 46a, b, c usw. Figur 19a zeigt ein Lineardisplay und Figur 19b zeigt ein Kreisbogendisplay.

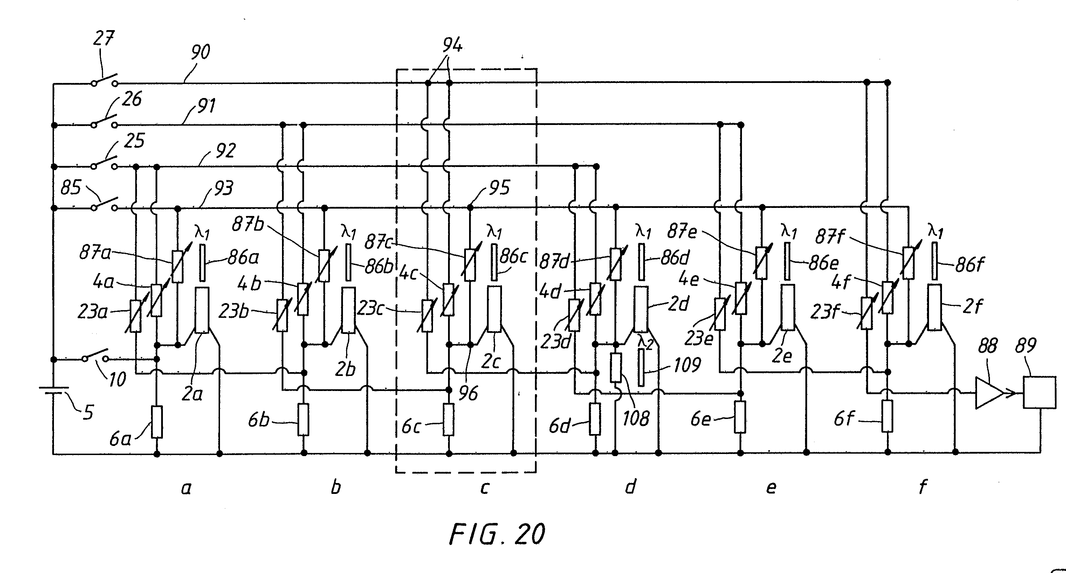

Bisher ist nur die Eingabe elektrischer Information in ein Display beschrieben worden. Figur 20 zeigt ein Schieberegister, das außer zur Eingabe elektrischer Information in Seriendarstellung mittels des Schalters 10 auch zur parallelen Eingabe optischer Informationen verwendet werden kann, die in elektrischer Seriendarstellung zu dem Verstärker 88 und der Elektronikeinheit 89, bei der es sich beispielsweise um einen Computer handeln kann, geleitet werden können. Das Schieberegister ist eine Modifikation des in Figur 10a gezeigten Schieberegisters, doch kann eine entsprechende Modifikation auch bei den übrigen beschriebenen Schieberegistern durchgeführt werden. Die Modifikation besteht darin, daß die Speicherelemente mit einem dritten Fotowiderstand 87 versehen sind, der das Speicherelement auf Eins stellen kann, wenn der Schalter 85 geschlossen ist und Licht im Bereich der Wellenlänge $\lambda_1$, welches durch das Filter 86 hindurchgelassen wird, den Fotowiderstand beleuchtet. Das Licht zur Beleuchtung der Modulatoren 2a, b, c usw. im Schieberegister wird so gewählt, daß es keine Wellenlängen im Bereich um $\lambda_1$ enthält. Zur Nullstellung (Löschfunktion) eines Speicherelementes kann eine Lichtwellenlänge $\lambda_2$ verwendet werden (siehe das Speicherelement d mit dem zusätzlichen Fotowiderstand 108).

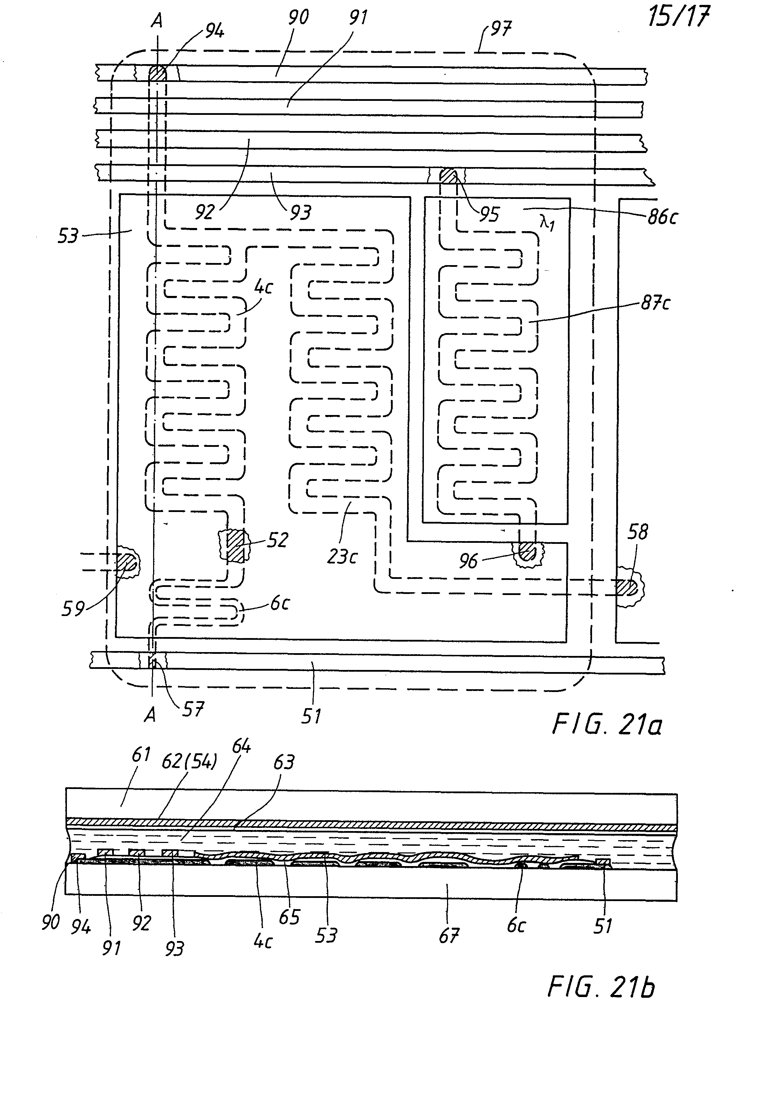

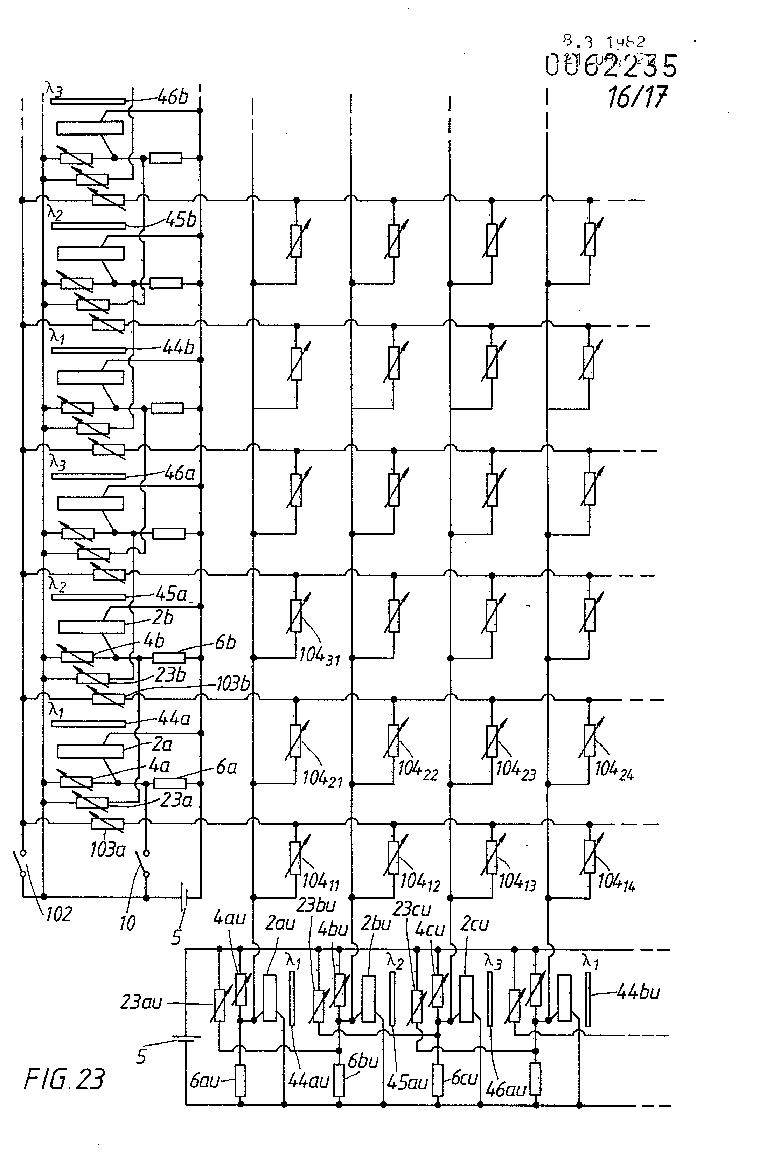

Wie ein Speicherelement in Figur 20 realisiert werden kann, zeigt Figur 21. In Figur 21b ist 61 eine obere transparente Platte, 62 eine transparente elektrisch leitende Schicht, 63 eine lichtpolarisierende Schicht, 64 ein Flüssigkristall,

...

- 20 -

53 eine transparente elektrisch leitende Schicht, 51, 90, 91, 92 und 93 elektrisch leitende Streifen, 65 eine Isolierschicht, 4c eine Fotowiderstandsschicht, 6c eine Widerstandsschicht und 67 eine Grundplatte. Figur 21a zeigt das Speicherelement von oben. Die Streifen 90, 91 und 92 sind die Steuerimpulsleitungen, die von den Schaltern 27, 26 bzw. 25 gesteuert werden (vgl. Figur 20). 93 ist die Leitung zur Steuerung des Einschreibens der optischen Information. Der Fotowiderstand 4c ist im Punkt 94 an den Streifen 90 und im Punkt 52 an die Elektrode 53 und das Widerstandselement 6c angeschlossen, das an seinem anderen Ende an den für sämtliche Speicherelemente gemeinsamen Leiter 51 im Punkt 57 angeschlossen ist. Der Fotowiderstand 23c ist mit seinem einen Ende über den Punkt 94 an den Streifen 90 und die Zuführleitung zum Widerstand 4c angeschlossen und mit dem anderen Ende an die Elektrode des nächsten Speicherelementes im Punkte 58 angeschlossen. Zum Einschreiben optischer Informationen in das Speicherelement ist die Elektrode 53 im Punkt 96 mit dem Fotowiderstand 87c verbunden, der an seinem anderen Ende an den Streifen 93 im Punkt 95 angeschlossen ist. 87c ist mit einem Interferenzfilter 86c belegt, welches das Licht ausfiltert, das für die elektrooptische Rückkopplung des Speicherelementes verwendet wird.

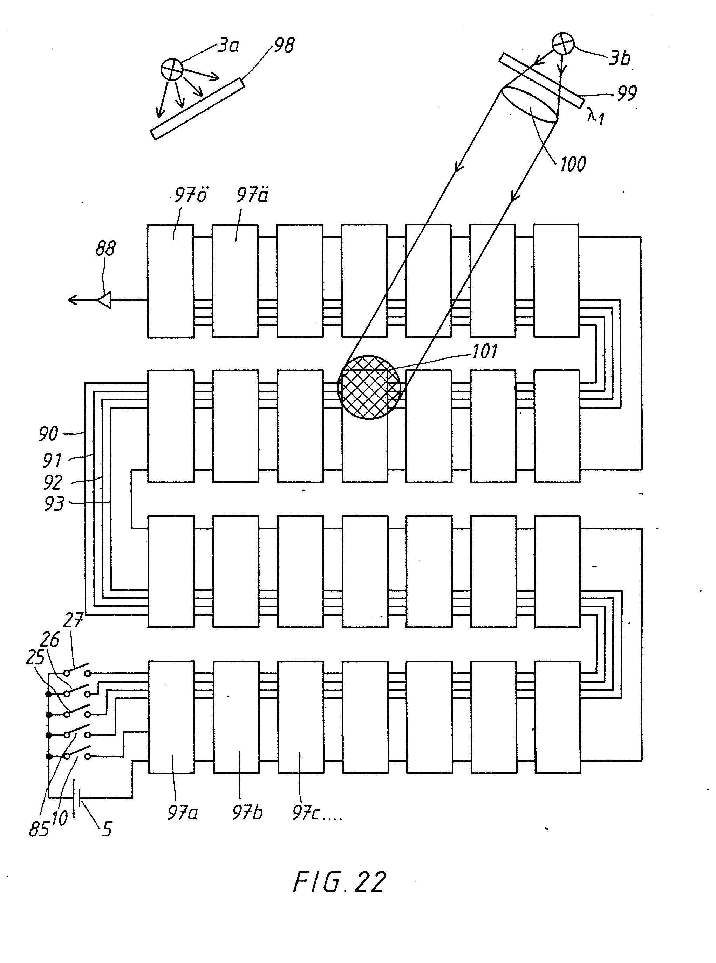

Mit Hilfe von Speicherelementen der in den Figuren 20 und 22 gezeigten Art kann ein kombiniertes Display und Digitizer aufgebaut werden, was in Figur 22 dargestellt ist. Durch eine Reihenschaltung der Speicherelemente erhält man ein langes Schieberegister, das von den Schaltern 25 bis 27 elektrisch gesteuert wird und in das elektrische Informationen (Einsen und Nullen) mit Hilfe des Schalters 10 eingespeist werden können. Die Information kann, nachdem sie das Schieberegister (97a, b, c usw.) passiert hat, mit Hilfe des Verstärkers 88 wieder ausgegeben werden. Die Funktion der Speicherelemente wird durch das Licht der Lichtquelle 3a sichergestellt, welches das Filter 98 passiert, dessen Aufgabe es ist, Licht im Bereich um die

...

Wellenlänge $\lambda_1$ auszufiltern. Das Licht von der Lichtquelle 3b passiert das Filter 99, welches das Licht im Bereich um die Wellenlänge $\lambda_1$ ausfiltert, und wird zur optischen Eingabe von Information in die Speicherelemente benutzt.

Die optisch eingegebene Information wird über den Verstärker 88 mit Hilfe der Schalter 25 - 27 ausgegeben. Beispielsweise kann die optische Informationseingabe mit einem optischen Schreibstift erfolgen.

Figur 23 zeigt schließlich einen optischen xy-Detektor, der mit einem Schieberegister der in Figur 20 gezeigten Art abgetastet werden kann. Das vertikale Schieberegister links in der Figur dient zur Adressierung der Reihen in der Fotowiderstandsmatrize mit den Fotoelementen $104_{11}$, $104_{21}$ ... $104_{12}$, $104_{22}$ usw. Das horizontale Schieberegister im unteren Teil der Figur wird benutzt, um abzulesen, welche Fotowiderstände in der von dem vertikalen Schieberegister adressierten Reihe beleuchtet sind. Die beiden Schieberegister werden optisch gesteuert. Die Adressierung der Reihen geschieht mit dem Schalter 10, und das Ablesen beleuchteter Fotowiderstände erfolgt durch einen in der Figur nicht dargestellten Verstärker, der an den Ausgang des horizontalen Schieberegisters angeschlossen ist. Die Arbeitsweise soll durch ein Beispiel beschrieben werden:

Es wird angenommen, daß eine Eins um zwei Schritte in dem vertikalen Schieberegister verschoben worden ist. Der optische Modulator 2b hat dann eine hohe Transmission und der Fotowiderstand 103b einen niedrigen Widerstand. Ferner wird angenommen, daß der Fotowiderstand $104_{23}$ beleuchtet wird und daß das horizontale Schieberegister auf Null gestellt ist. Wenn der Schalter 102 jetzt für einen Augenblick geschlossen wird, wird über die niederohmigen Fotowiderstände 103b und $104_{23}$ die Spannung am Modulator 2cu hoch genug, um dieses Speicherelement auf Eins zu stellen. Durch Auswechseln dieser Eins erhält man dann durch die Anzahl der Verschiebungsschritte die Position des beleuchteten Foto-

...

08.03.1982
21 087 PE
0062235

widerstandes in x-Richtung. Die Position in y-Richtung erhält man als aus der Anzahl Schritte, um welche eine Eins in dem vertikalen Register verschoben wird.

Die in dieser Beschreibung behandelten elektrooptischen Speicherelemente, Kippstufen und Schieberegister kann man in einer großen Anzahl von Möglichkeiten kombinieren, um Displays und Digitizer mit unterschiedlichen Eigenschaften zu erhalten.

Die vorstehend beschriebenen Anordnungen können im Rahmen des offenbarten allgemeinen Erfindungsgedankens in vielfacher Weise variiert werden.

Patentanwalt und Rechtsanwalt
Dr.-Ing. Dipl.-Ing. Joachim B o e c k e r

6 Frankfurt / Main 1
Rathenauplatz 2 - 8
Telefon: (06 11) *28 23 55
Telex: 4 189 066 itax d

- 23 -

P a t e n t a n s p r ü c h e :

1.    Anordnung zur Umwandlung von Information aus der elektrischen Form in die  optische Form und/oder umgekehrt, wobei die optische Informationsform eine in einer, zwei oder drei Dimensionen (Richtungen) zeitlich variierende Lichtintensität und/oder Lichtpolarisation und/oder Spektralzusammensetzung ist und wobei die Umwandlung der Information aus der elektrischen in die optische Form durch optische Modulatoren, wie z.B. Flüssigkristalle, erfolgt und die Umwandlung aus der optischen Form in die elektrische Form durch Fotodetektoren erfolgt, mit Baugruppen, die in einer, zwei oder drei Dimensionen die optischen Modulatoren zeitlich steuern und/oder abtasten und die Fotodetektoren abtasten und/oder steuern, wobei die Baugruppen die genannten Modulatoren und Fotodetektoren enthalten können, d a - d u r c h   g e k e n n z e i c h n e t , daß die genannten Baugruppen ein oder mehrere elektrooptisch rückgekoppelte Kreise (Fig. 3, 4, 5, 6) sind, in denen sich mindestens ein optischer Modulator (2), z.B. ein Flüssigkristallmodulator, im Strahlengang zwischen mindestens einer Lichtquelle (3), z.B. einer Leuchtdiode oder Laserdiode, und mindestens einem Fotodetektor (4), z.B. einem Fotowiderstand oder einer Fotodiode, befindet, daß der Fotodetektor (4) in mindestens einen elektrischen Kreis (4, 5, 6) eingeschaltet ist, an welchen der optische Modulator (2) derart angeschlossen ist, daß man über einen Rückkopplungskreis, dessen Verhalten - in Kreisrichtung gesehen - bestimmt wird durch die Lichttransmission des op-

. . .

- 24 -

tischen Modulators (2), die elektrische Eigenschaft des
Fotodetektors, das elektrische Eingangssignal des optischen
Modulators (2) und wieder die Lichttransmission des optischen Modulators (2), eine positive und negative Rückkopplung erhält, und/oder daß die elektrooptisch rückgekoppelten Kreise aus mindestens zwei verschiedenen optischen Modulatoren (2a, 2b) und Fotodetektoren (4a, 4b)
bestehen, daß die Fotodetektoren (4a, 4b) in elektrische
Kreise (5, 6a, 4a bzw. 5, 6b, 4b) eingeschaltet sind, daß
mindestens eine Lichtquelle (3) den einen Fotodetektor (4a)
durch den einen Modulator (2a) und den anderen Fotodetektor
(4b) durch den anderen Modulator (2b) beleuchtet, und daß
der eine Modulator (2a) an den elektrischen Kreis des
zweiten Fotodetektors (4b) und der zweite Modulator (2b)
an den elektrischen Kreis des ersten Fotodetektors (4a)
derart angeschlossen ist, daß sich eine elektrooptisch
rückgekoppelte Kreuzschaltung ergibt.

2. Anordnung nach Anspruch 1, d a d u r c h  g e -
k e n n z e i c h n e t , daß in dem Rückkopplungskreis
ein nichtlineares Element mit negativer Verstärkung in
~~Verstärkung in~~ mindestens einem Signalbereich (A - C,
Fig. 5c) und positiver Verstärkung in mindestens einem
anderen Signalbereich (C - D, Fig. 5c) vorhanden ist,
wodurch die Rückkopplung in Abhängigkeit von der Signalamplitude positiv oder negativ wird.

3. Anordnung nach Anspruch 2, d a d u r c h  g e -
k e n n z e i c h n e t , daß der optische Modulator (2)
ein Flüssigkristall (64, Fig. 14b) ist, dessen Polarisationsdrehung derart angeordnet ist, daß bei kleiner elektrischer Feldstärke die Polarisationsrichtung des den
Flüssigkristall passierenden Lichtes mit zunehmender
Feldstärke so gedreht wird, daß sich der Unterschied zwischen den Polarisationsrichtungen des Lichts von dem
Flüssigkristall und des Polarisators 90° oder 0° nähert,
was einer Senkung oder Erhöhung der Lichttransmission

...

- 25 -

durch den optischen Modulator (2) entspricht, und daß bei
größerer elektrischer Felderstärke der Unterschied zwischen den genannten Polarisationsrichtungen sich von 90°
bzw. 0° entfernt, wodurch für kleinere Spannungen am optischen Modulator (2) dieser eine negative bzw. positive
Verstärkung und für größere Spannungen eine positive bzw.
negative Verstärkung hat.

4. Anordnung nach einem der vorhergehenden Ansprüche,
d a d u r c h   g e k e n n z e i c h n e t , daß zwei
oder mehr der genannten elektrooptisch rückgekoppelten Kreise elektrisch zu Schieberegistern verbunden sind, welche in
elektrischer und optischer Form die Information in ein,
zwei oder drei Richtungen verschieben können.

5. Anordnung nach Anspruch 4, d a d u r c h   g e -
k e n n z e i c h n e t ,   daß die Informationsübertragung
zwischen den elektrooptisch rückgekoppelten Kreisen (Speicherelementen) mittels Fotodetektoren (23b), z.B. Fotowiderständen (23b) oder Fotodioden (33b), geschieht.

6. Anordnung nach Anspruch 5, d a d u r c h   g e -
k e n n z e i c h n e t , daß die Informationsübertragung
zwischen den Speicherelementen des Schieberegisters von
Steuerimpulsen gesteuert wird, welche die Fotodetektoren
(23b) elektrisch an das Speicherelement (c), in welches die
Information übertragen werden soll, in solcher Weise durchschalten, daß dieses Speicherelement (c) denselben Zustand
einnimmt, den das Speicherelement (b) innehat, das der
Fotodetektor (23b) abtastet, und daß die genannten Steuerimpulse zeitlich derart angeordnet sind, daß die Informationsübertragung nur über eine vorgegebene Anzahl von
Schritten im Schieberegister erfolgen kann, oder daß die
genannten Steuerimpulse elektrisch nur in jeden zweiten
oder dritten Fotodetektor zur Zeit wirksam werden, so daß
die Informationsübertragung zwischen einer bestimmten Anzahl von Speicherelementen isoliert vorgenommen werden kann.

...

7. Anordnung nach Anspruch 5, d a d u r c h   g e -
k e n n z e i c h n e t, daß die Informationsübertragung
zwischen Speicherelementen des Schieberegisters von Steuerimpulsen in Form von Lichtimpulsen gesteuert wird, wobei
diese Lichtimpulse den Speicherelementen über optische Filter, z.B. Interferenzfilter, zugeführt werden und zeitlich
derart angeordnet sind, daß die Informationsübertragung nur
über eine vorgegebene Anzahl von Schritten erfolgen kann,
oder daß die Lichtimpulse so gewählt sind, daß nur jedes
zweite oder dritte Speicherelement zur Zeit angesteuert
wird, wobei die Informationsübertragung zwischen einer bestimmten Anzahl von Speicherelementen erfolgen kann.

8. Anordnung nach Anspruch 6, d a d u r c h   g e -
k e n n z e i c h n e t, daß jedes Speicherelement (a, b,
c usw., Fig. 10a) aus mindestens einem Fotowiderstand (4b)
besteht, der mit mindestens einem Widerstand (6b) in Reihe
geschaltet ist, der von dem Licht der Lichtquelle (3) weniger widerstandsabhängig ist als der Fotowiderstand (4b),
daß diese in Reihe liegenden Widerstände über einen elektrischen Schalter (26) an eine Spannungsquelle (5) angeschlossen sind, daß der optische Modulator (2b) elektrisch
über einen der Widerstände (4b, 6b) derart angeschlossen
wird, daß man bei kleinen Spannungen an den Modulatorelektroden (62, 53, Fig. 14b) eine negative elektrooptische
Rückkopplung und bei größeren Spannungen eine positive Rückkopplung erhält, und daß an den Mittelpunkt der Widerstandsreihenschaltung (4c, 6c) des im Schieberegister unmittelbar
folgenden Speicherelementes (c) mindestens ein Fotowiderstand (23b) angeschlossen ist, durch dessen Steuerung Information zwischen zwei Speicherelementen (b, c) übertragen
werden kann.

9. Anordnung nach Anspruch 8, d a d u r c h   g e -
k e n n z e i c h n e t, daß der genannte Fotowiderstand
(17b, Fig. 8b) im Strahlengang des von einem separaten
optischen Modulator (2a1, Fig. 8b) kommenden Lichtes liegt

...

und über einen elektrischen Schalter (21a) an eine Spannungsquelle (5) angeschlossen ist oder daß der genannte Fotowiderstand (23b, Fig. 10a) im Strahlengang des von demselben
optischen Modulator (2b) kommenden Lichtes liegt, wie der
andere, oben genannte Fotowiderstand (4b).

10. Anordnung nach Anspruch 8, d a d u r c h   g e -
k e n n z e i c h n e t,  daß die Eingabe von Information
in das Schieberegister durch mindestens einen elektrischen
Schalter (10, 22) steuerbar ist, der zwischen der Spannungsquelle (5) und dem Mittelpunkt der genannten Widerstandsreihenschaltung (6a, 4a, Fig. 7, 14a, 6a, Fig. 8b usw.)
liegt, und daß dieser Schalter die Spannung am optischen
Modulator auf Werte zwingen kann, die einer netagiven oder
positiven elektrooptischen Rückkopplung entsprechen.

11. Anordnung nach Anspruch 7, d a d u r c h   g e -
k e n n z e i c h n e t, daß jedes Speicherelement (a, b,
c, usw.) aus mindestens einem Fotowiderstand (4b) besteht,
der mit mindestens einem Widerstand (6b) in Reihe geschaltet ist, der dem betreffenden Licht gegenüber weniger
empfindlich ist als der Fotowiderstand (4b),    daß diese
in Reihe liegenden Widerstände, eventuell über einen elektrischen Schalter (1) an eine Spannungsquelle (5) angeschlossen werden, daß der optische Modulator (2b) elektrisch
über einen der Widerstände (4b, 6b) angeschlossen ist, daß
der Mittelpunkt der Widerstandsreihenschaltung (4b, 6b) an
einen Fotowiderstand (23a) der unmittelbar vorausgehenden
Speicherzelle (a) angeschlossen ist, daß der Mittelpunkt der
Widerstandsreihenschaltung  (4c, 6c) der unmittelbar folgenden Speicherzelle an die Speicherzelle über einen Widerstand (23b) angeschlossen ist, der im Strahlengang des von
einem optischen Filter und/oder einem Modulator (2b) der
Speicherzelle kommenden Lichtes liegt, und daß der Modulator der Speicherzelle mit einem optischen Filter versehen
ist.

...

12. Anordnung nach Anspruch 11, d a d u r c h g e - k e n n z e i c h n e t , daß zur optischen Adressierbarkeit der Speicherelemente die Transmissionsspektren der optischen Filter (38, 39, 44, 45, 46 usw.) für jedes zweite oder jedes dritte Speicherelement gleich sind, daß für jede Art von Filterspektrum eine Lichtquelle vorhanden ist, wie z.B. eine Leucht- oder Laserdiode, deren Licht die seiner Zusammensetzung zugeordneten optischen Filter gut, die übrigen Filter jedoch nur in gewissem Ausmaße passieren kann, und daß diese Adressierung durch elektrische Schaltung der Lichtquellen (3a, b, c usw.) zeitlich veränderbar ist.

13. Anordnung nach einem der vorhergehenden Ansprüche, d a d u r c h g e k e n n z e i c h n e t , daß die elektrooptisch rückgekoppelten Kreise in an sich bekannter Weise, wie z.B. Dünnfilm-, Dickfilm-, Halbleiter-IC-Technik, auf einem Substrat (67) aus beispielsweise Glas, Quarz, Saphir oder Silizium integriert sind, daß die derart integrierten Kreise mit einem flüssigen Kristall (64) belegt sind, der gegen das Substrat mit Hilfe einer transparenten Scheibe (61) aus beispielsweise Glas oder Quarz gepreßt wird, welche Scheibe mit einer transparenten, elektrisch leitenden Schicht (62) und einem optischen Polarisator (63) belegt ist.

14. Anordnung nach Anspruch 13, d a d u r c h g e - k e n n z e i c h n e t , daß die elektrooptisch rückgekoppelten Kreise Fotowiderstände (4b) und andere Widerstände (23b) enthalten, die auf dem Substrat (67) aufgebracht sind, daß sie mit einer elektrisch isolierenden Schicht (65) versehen sind, die in den Punkten (52, 57) abgeätzt ist, in welchen die Widerstände (4b, 23b) an elektrisch leitende Schichten (53, 51) angeschlossen werden sollen, und daß über den Widerstandselementen (4b, 23b) transparente Schichten aus elektrisch leitendem Material liegen, die als Leitungen (51) und Elektroden (53) für die optischen Modulatoren (64) dienen.

...

15. Anordnung nach Anspruch 13, d a d u r c h   g e -
k e n n z e i c h n e t , daß die elektrooptisch rückgekoppelten Kreise Fotodioden (7b, 33b) enthalten einerseits
für die Rückkopplung selbst (7b) und andererseits zur Übertragung von Information zwischen verschiedenen Kreisen (33b),
daß die genannten Fotodioden auf ein Substrat (67) aufgebracht sind, beispielsweise mit Flüssigkeitsepitaxi oder
MOCVD (Metal Organic Chemical Vapour Deposition), und daß
die optischen Modulatoren (2) aus Flüssigkristallen bestehen, die von Metallelektroden auf dem Substrat (67) und dem
Deckglas (61) moduliert werden.


16. Anordnung nach Anspruch 8 oder 11, d a d u r c h
g e k e n n z e i c h n e t ,  daß jedes Speicherlement mit
mindestens drei Fotowiderständen (4b, 23b und 83b) versehen
ist, wobei ein Fotowiderstand (4b) für die elektrooptische
Rückkopplung, einer (23b) zur Vorwärtsbeförderung von Information im Schieberegister und einer (83b) zur Rückwärtsbeförderung von Information im Schieberegister (83b) dient,
und daß die Richtung aus der Reihenfolge der Folge von
elektrischen oder optischen Steuerimpulsen bestimmt wird.


17. Anordnung nach Anspruch 8 oder 11, d a d u r c h
g e k e n n z e i c h n e t ,  daß zum Einlesen optischer
Informationen in das Schieberegister ein Speicherelement
oder mehrere Speicherelemente eines Schieberegisters einen
Fotowiderstand (86) enthalten, der bei Beleuchtung die
Spannung am Modulator (2) erhöht oder senkt, so daß man
eine positive oder negative Rückkopplung erhält.


18. Anordnung nach Anspruch 17, d a d u r c h   g e -
k e n n z e i c h n e t , daß der Fotowiderstand (86)
zwischen zwei Speicherelemente zweier  verschiedener Schieberegister geschaltet ist, mittels derer eine xy-Matrix aus
Fotowiderständen ablesbar ist.


19. Anordnung nach Anspruch 8 oder 11, d a d u r c h

...

g e k e n n z e i c h n e t, daß die genannten Schieberegister an eine xy-Matrix (Fig. 17) zur Modulation eines Displays auf Flüssigkristallbasis geschaltet sind.

20. Anordnung nach Anspruch 8 oder 11, d a d u r c h g e k e n n z e i c h n e t, daß die genannten Schieberegister auf einer Glasplatte zur Bildung eines Displays angeordnet sind, wobei das Display entweder nur aus reihengeschalteten Speicherlementen (Fig. 19, 22) oder aus kombinierten reihen- oder parallelgeschalteten Speicherlementen (Fig. 16) besteht.

21. Anordnung nach Anspruch 19, d a d u r c h g e - k e n n z e i c h n e t, daß das eine Schieberegister (60a-f) mit zugehörigen Matrixelektroden (81a-e) auf einer Glasplatte ausgelegt ist, daß das andere Schieberegister (60g-l) mit zugehörigen Matrixelektroden (81g-k) auf einer anderen Glasplatte ausgelegt ist und daß die Glasplatten mit einer zwischengefügten Schicht aus Flüssigkristallen aneinandergelegt sind.

22. Anordnung nach Anspruch 17, d a d u r c h g e - k e n n z e i c h n e t, daß ein optischer Schreibstift zum Einschreiben von Information in ein Display benutzt wird, das aus den genannten Schieberegistern aufgebaut ist, daß die optisch eingeschriebene Information in elektrischer Form an einen Computer zur Speicherung und Verarbeitung gegeben werden kann und daß die verarbeitende Information oder eine andere Information zu Display-Zwecken elektrisch in das Schieberegister eingebbar ist, wodurch eine zweigerichtete Mensch-Maschinen-Kommunikation entsteht.

...

*FIG. 1*

*FIG. 2*

*FIG. 4a*

*FIG. 4b*

*FIG. 4c*

*FIG. 4d*

FIG.3a

FIG.3b

FIG.3c

FIG.3d

FIG.3e

FIG.3f

FIG.5a

FIG. 5b

FIG.5c

*Transmission*

$U_{in}$

$0$   $U_{trigg}$   $U_{max}$

FIG.6a

FIG.6b

FIG.7

FIG.8a

FIG.8b

8.3.1982
21 087 PE

0062235

6/17

FIG. 9

FIG. 10a

FIG. 10b

FIG.11

3.3.1982
21 087 PE
0062235
7/17

FIG. 12

FIG. 13a

FIG. 13b

FIG. 14a

A - A    FIG. 14b

FIG. 15a

FIG. 15b

FIG. 16a

FIG.16b

## FIG.17

FIG. 18

FIG.19a

FIG.19b

FIG. 20

A    94    90    91    97

53    92    93    95    λ₁    86c

4c    87c

52    23c    96    58

59    6c

A    57    51    57    631

**FIG. 21a**

61    62(54)    64    63

90    94    92    93    4c    65    53    67    6c    51
91

**FIG. 21b**

FIG.23

FIG.22